# EUROPEAN PATENT APPLICATION

(11) **EP 4 738 871 A1**
(43) Date of publication of application: **06.05.2026**
(21) Application number: 24832069.9
(22) Date of filing: 28.06.2024
(51) Int. Cl.: H04N 25/773, H04N 25/70

(54) **PHOTOELECTRIC CONVERSION DEVICE AND PHOTOELECTRIC CONVERSION SYSTEM**

(30) Priority: 29.06.2023 JP 2023106781
(71) Applicant: Canon Kabushiki Kaisha, Tokyo, 146-8501 (JP)
(72) Inventor: TOJIMA Kenzo, Tokyo 146-8501 (JP); MORIMOTO Kazuhiro, Tokyo 146-8501 (JP)
(74) Representative: Canon Europe Limited
(86) International application number: PCT/JP2024/023447
(87) International publication number: WO 2025/005211

(57) **Abstract**

A photoelectric conversion apparatus includes a first APD, a first pulse generating circuit that generates a first pulse signal, based on an output from the first APD, a first switch that is provided between a first power supply that applies a first voltage and a first terminal of the first APD, and a second switch that is provided between a second power supply that applies a second voltage and the first terminal of the first APD. When the first switch is turned on, the first APD enters a recharge state. When the first switch is turned off, the first APD enters a standby state. When the second switch is turned on, the first APD enters an inactive state. When the second switch is turned off, the first APD enters an active state. A period during which the first switch is on differs from a period during which the second switch is on.

## Description

### Technical Field

The present invention relates to structures of a photoelectric conversion apparatus and a photoelectric conversion system.

### Background Art

A known photoelectric conversion apparatus includes pixels including multiple avalanche photodiodes (APDs).

PTL 1 discloses an APD, a quenching circuit that is connected to the APD, a signal controlling circuit into which a signal outputted from the APD is inputted, and a pulse generating circuit that is connected to the quenching circuit and the signal control circuit. A pulse signal that is generated by the pulse generating circuit causes the turning on and off of the quenching circuit to be controlled and causes the output signal of the APD to be reset, and a pulse signal depending on an incident photon is outputted even under high luminance.

### Citation List

### Patent Literature

PTL 1: Japanese Patent Laid-Open No. 2020-123847

### Summary of Invention

### Technical Problem

The APD includes a single electrode for collecting electric charges, and all of the electric charges are collected by the electrode such that avalanche multiplication occurs. Accordingly, device characteristics dependent on the avalanche multiplication can be degraded. Solution to Problem

According to an aspect of the present invention, a photoelectric conversion apparatus includes: a first avalanche photodiode; a first pulse generating circuit that generates a first pulse signal, based on an output from the first avalanche photodiode; a first switch that is provided between a first power supply that applies a first voltage and a first terminal of the first avalanche photodiode; and a second switch that is provided between a second power supply that applies a second voltage different from the first voltage and the first terminal of the first avalanche photodiode. When the first switch is turned on, the first avalanche photodiode enters a recharge state, when the first switch is turned off, the first avalanche photodiode enters a standby state, when the second switch is turned on, the first avalanche photodiode enters an inactive state, when the second switch is turned off, the first avalanche photodiode enters an active state, and a period during which the first switch is on differs from a period during which the second switch is on.

According to another aspect of the present invention, a photoelectric conversion apparatus includes: a first avalanche photodiode; a first pulse generating circuit that generates a first pulse signal, based on an output from the first avalanche photodiode; a first power supply that applies a first voltage to a first terminal of the first avalanche photodiode via a first switch; a second power supply that applies a second voltage different from a voltage of the first power supply to a second terminal of the first avalanche photodiode; and a third power supply that applies a third voltage different from the voltage of the first power supply and a voltage of the second power supply to the first terminal via a second switch. A period during which the first switch is on differs from a period during which the second switch is on.

### Advantageous Effects of Invention

The frequency of use of an electrode for collecting electric charges is reduced, and consequently, device characteristics dependent on avalanche multiplication are inhibited from being degraded.

### Brief Description of Drawings

[Fig. 1] Fig. 1 illustrates the structure of a photoelectric conversion apparatus according to an embodiment.
[Fig. 2] Fig. 2 illustrates an example of arrangement of a sensor substrate of the photoelectric conversion apparatus according to the embodiment.
[Fig. 3] Fig. 3 illustrates an example of arrangement of a circuit substrate of the photoelectric conversion apparatus according to the embodiment.
[Fig. 4A] Fig. 4A is a block diagram including an equivalent circuit of a photoelectric conversion element of the photoelectric conversion apparatus according to the embodiment.
[Fig. 4B] Fig. 4B is a block diagram including an equivalent circuit of the photoelectric conversion element of the photoelectric conversion apparatus according to the embodiment.
[Fig. 5] Fig. 5 illustrates a relationship between the operation of an APD of the photoelectric conversion apparatus according to the embodiment and an output signal.
[Fig. 6] Fig. 6 illustrates an example of the structures of a signal processing circuit and a photoelectric conversion element according to a first embodiment.
[Fig. 7A] Fig. 7A is a timing chart illustrating the operation of the signal processing circuit according to the first embodiment.
[Fig. 7B] Fig. 7B is a timing chart illustrating the operation of the signal processing circuit according to the first embodiment.
[Fig. 8A] Fig. 8A is a schematic diagram of the photoelectric conversion element according to the first embodiment.
[Fig. 8B] Fig. 8B is a schematic diagram of the photoelectric conversion element according to the first embodiment.
[Fig. 9] Fig. 9 illustrates a sectional view of a photoelectric conversion element according to a second embodiment.
[Fig. 10] Fig. 10 is a potential diagram of the photoelectric conversion element according to the second embodiment.
[Fig. 11A] Fig. 11A is a plan view of the photoelectric conversion element according to the second embodiment.
[Fig. 11B] Fig. 11B is a plan view of the photoelectric conversion element according to the second embodiment.
[Fig. 12] Fig. 12 is a potential diagram of the photoelectric conversion element according to the second embodiment.
[Fig. 13] Fig. 13 illustrates a sectional view of a photoelectric conversion element according to a third embodiment.
[Fig. 14] Fig. 14 illustrates a sectional view of a trench structure of the photoelectric conversion element according to the third embodiment.
[Fig. 15A] Fig. 15A illustrates a plan view of the photoelectric conversion element according to the third embodiment.
[Fig. 15B] Fig. 15B illustrates a plan view of the photoelectric conversion element according to the third embodiment.
[Fig. 16] Fig. 16 illustrates a sectional view of a photoelectric conversion element according to a fourth embodiment.
[Fig. 17A] Fig. 17A illustrates a plan view of the photoelectric conversion element according to the fourth embodiment.
[Fig. 17B] Fig. 17B illustrates a plan view of the photoelectric conversion element according to the fourth embodiment.
[Fig. 18A] Fig. 18A is a schematic diagram of a photoelectric conversion element according to a fifth embodiment.
[Fig. 18B] Fig. 18B is a schematic diagram of the photoelectric conversion element according to the fifth embodiment.
[Fig. 18C] Fig. 18C is a schematic diagram of the photoelectric conversion element according to the fifth embodiment.
[Fig. 19A] Fig. 19A is a plan view of a photoelectric conversion element according to a sixth embodiment.
[Fig. 19B] Fig. 19B is a plan view of the photoelectric conversion element according to the sixth embodiment.
[Fig. 20] Fig. 20 is a functional block diagram of a photoelectric conversion system according to a seventh embodiment.
[Fig. 21A] Fig. 21A is a functional block diagram of a photoelectric conversion system according to an eighth embodiment.
[Fig. 21B] Fig. 21B is a functional block diagram of the photoelectric conversion system according to the eighth embodiment.
[Fig. 22] Fig. 22 is a functional block diagram of a photoelectric conversion system according to a ninth embodiment.
[Fig. 23] Fig. 23 is a functional block diagram of a photoelectric conversion system according to a tenth embodiment.
[Fig. 24A] Fig. 24A is a schematic diagram of a photoelectric conversion system according to an eleventh embodiment.
[Fig. 24B] Fig. 24B is a schematic diagram of a photoelectric conversion system according to the eleventh embodiment.

### Description of Embodiments

Embodiments described later are used to embody the technical concept of the present invention and do not limit the present invention. The sizes of components and positional relationships therebetween are exaggeratedly illustrated in the drawings for clarity of description in some cases. In the description below, like components are designated by using like reference signs, and the description thereof is omitted in some cases.

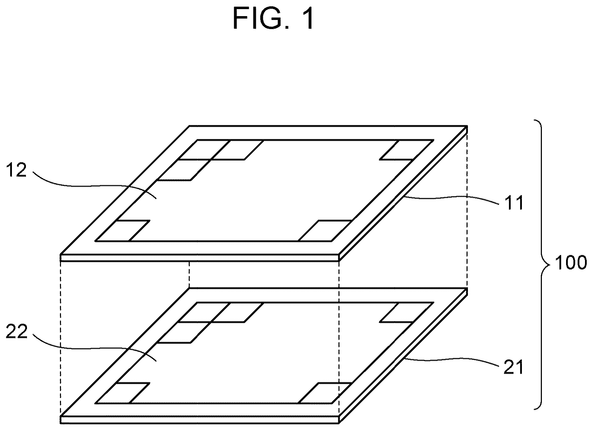

Structures common to photoelectric conversion apparatuses according to the embodiments will be described with reference to Fig. 1 to Fig. 5. Each photoelectric conversion apparatus includes a SPAD pixel including an avalanche diode (APD). The conductivity type of an electric charge that is used as a signal charge in a pair of electric charges that are generated by the avalanche diode is referred to as a first conductivity type. As for the first conductivity type, electric charges having the same polarity as the signal charge are majority carriers. A conductivity type opposite to the first conductivity type is referred to as a second conductivity type. In an example described below, the signal charge is an electron, the first conductivity type is an N-type, and the second conductivity type is a P-type, but the signal charge may be a hole, the first conductivity type may be the P-type, and the second conductivity type may be the N-type.

In the case where the signal charge is an electron, a signal is read from the cathode of the APD. In the case where the signal charge is a hole, a signal is read from the anode of the APD. Accordingly, the cathode and anode of the APD are inversely related.

In the present specification, a "plan view" refers to viewing in a direction perpendicular to a light incident surface of a semiconductor layer in which a photoelectric conversion element described later is disposed. A cross-section refers to a section in the direction perpendicular to the light incident surface of the semiconductor layer in which the photoelectric conversion element is disposed. In the case where the light incident surface of the semiconductor layer is microscopically rough, the plan view is defined macroscopically based on the light incident surface of the semiconductor layer.

In the description below, the anode of the APD has a fixed electric potential, and a signal is acquired from the cathode. Accordingly, a semiconductor region of the first conductivity type in which the electric charges having the same polarity as the signal charge are the majority carriers is an N-type semiconductor region, and a semiconductor region of the second conductivity type in which electric charges having polarity that differs from that of the signal charge are majority carriers is a P-type semiconductor region. The present invention is achieved even in the case where the cathode of the APD has a fixed electric potential, and a signal is acquired from the anode. In this case, the semiconductor region of the first conductivity type in which the electric charges having the same polarity as the signal charge are the majority carriers is the P-type semiconductor region, and the semiconductor region of the second conductivity type in which the electric charges having polarity that differs from that of the signal charge are the majority carriers is the N-type semiconductor region. In a case described below, one of nodes of the APD has a fixed electric potential, but the electric potentials of both of the nodes may vary.

In the case where the term "impurity concentration" is merely used in the present specification, the term means net impurity concentration acquired by subtracting a portion compensated by impurities of an opposite conductivity type. That is, the "impurity concentration" refers to NET doping concentration. A region in which P-type added dopant concentration is higher than N-type added dopant concentration is the P-type semiconductor region. Conversely, a region in which the N-type added dopant concentration is higher than the P-type added dopant concentration is the N-type semiconductor region.

Components common to the embodiments will now be described.

Fig. 1 illustrates the structure of a photoelectric conversion apparatus 100 according to an embodiment of the present invention. In an example described below, the photoelectric conversion apparatus 100 is a stacked photoelectric conversion apparatus. That is, in a photoelectric conversion apparatus described by way of example, two substrates of a sensor substrate 11 and a circuit substrate 21 are stacked and electrically connected to each other. However, the photoelectric conversion apparatus is not limited thereto. For example, the photoelectric conversion apparatus may be a photoelectric conversion apparatus in which a structure that is included in the sensor substrate 11 and a structure that is included in the circuit substrate are disposed in a common semiconductor layer as described later. The photoelectric conversion apparatus in which the structure that is included in the sensor substrate 11 and the structure that is included in the circuit substrate are disposed in the common semiconductor layer is also referred to below as a non-stacked photoelectric conversion apparatus.

The sensor substrate 11 includes a first wiring structure and a first semiconductor layer containing photoelectric conversion elements 102 described later. The circuit substrate 21 includes a second wiring structure and a second semiconductor layer containing circuits such as signal processing circuits 103 described later. The photoelectric conversion apparatus 100 includes the second semiconductor layer, the second wiring structure, the first wiring structure, and the first semiconductor layer that are stacked in this order.

Fig. 1 illustrates a backside-illumination photoelectric conversion apparatus in which light is incident on a first surface, and a circuit substrate is disposed on a second surface opposite the first surface. In the case of a non-stacked photoelectric conversion apparatus, a surface on which a transistor of a signal processing circuit is disposed is referred to as a second surface. In the case of a backside-illumination photoelectric conversion apparatus, a first surface opposite a second surface of a semiconductor layer serves as the light incident surface. In the case of a frontside-illumination photoelectric conversion apparatus, a second surface of a semiconductor layer serves as the light incident surface.

In the following description, the sensor substrate 11 and the circuit substrate 21 are described as diced chips, but are not limited to chips. For example, each substrate may be a wafer. The substrates may be stacked as wafers and subsequently diced, or after being diced into chips, the chips may be stacked and bonded.

The sensor substrate 11 has a pixel region 12, and the circuit substrate 21 has a circuit region 22 in which a signal that is detected in the pixel region 12 is processed.

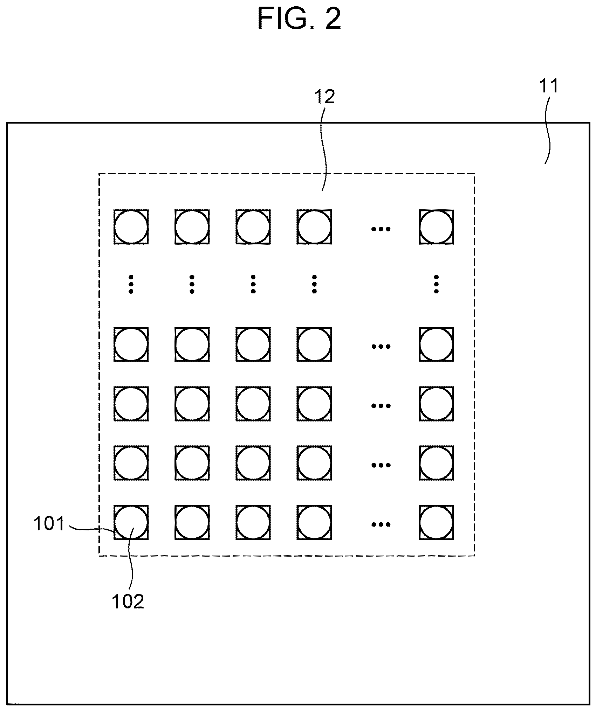

Fig. 2 illustrates an example of arrangement of the sensor substrate 11. Pixels 101 that include the photoelectric conversion elements 102 including avalanche photodiodes (referred to below as APDs) are arranged in a two-dimensional array in plan view and form the pixel region 12.

The pixels 101 are typically pixels for forming an image but may not form an image when used for TOF (Time of Flight). That is, the pixels 101 may be pixels for measuring the quantity of light and a time at which light arrives.

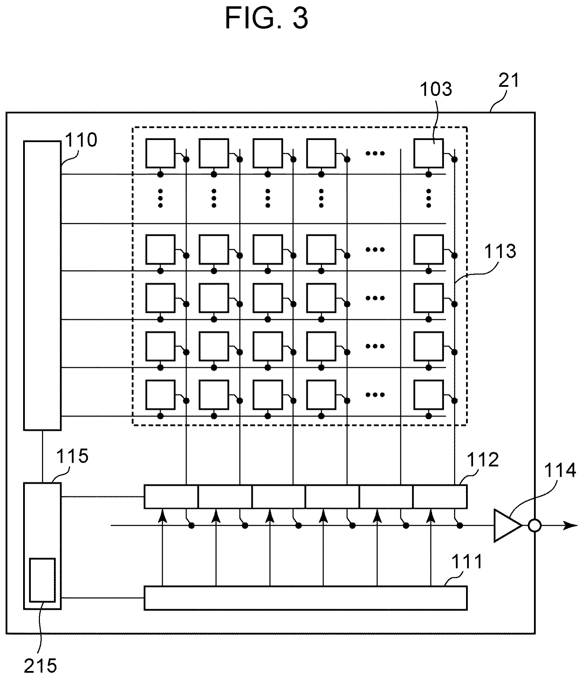

Fig. 3 illustrates the structure of the circuit substrate 21. The signal processing circuits 103 that process electric charges photoelectrically converted by the photoelectric conversion elements 102 in Fig. 2, a reading circuit 112, a control-pulse generating unit 115, a horizontal scanning circuit unit 111, signal lines 113, and a vertical scanning circuit unit 110 are included.

The photoelectric conversion elements 102 in Fig. 2 and the signal processing circuits 103 in Fig. 3 are electrically connected to each other with connection wiring lines that are provided for the respective pixels interposed therebetween.

The vertical scanning circuit unit 110 receives a control pulse supplied from the control-pulse generating unit 115 and supplies a control pulse to each pixel. Logic circuits such as a shift register and an address decoder are used for the vertical scanning circuit unit 110.

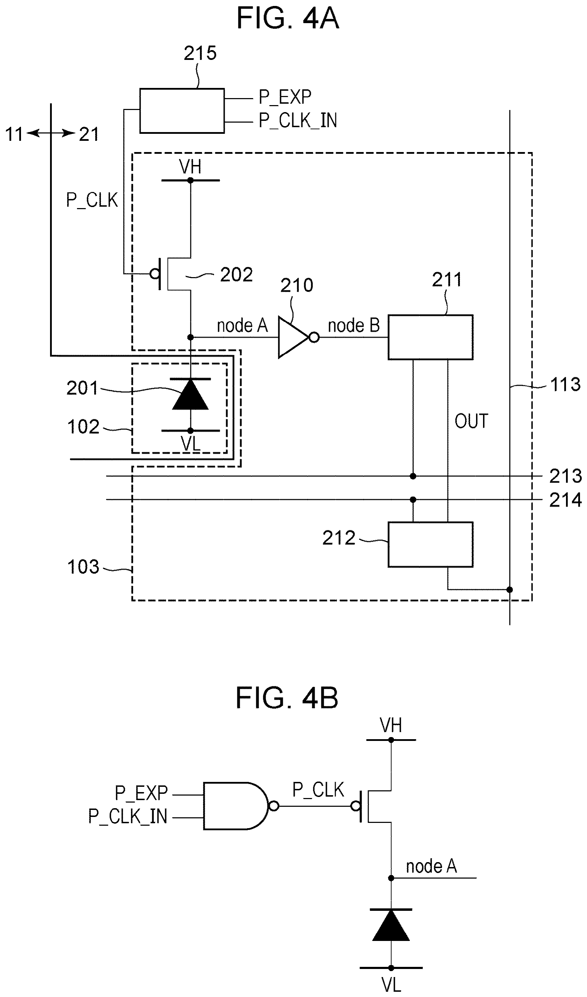

The control-pulse generating unit 115 includes a signal generating unit 215 that generates a control signal P_CLK of a switch described later. The signal generating unit 215 generates a pulse signal for controlling the switch as described later. For example, the signal generating unit 215 may generate the control signal P_CLK in common for multiple pixels in the pixel region as illustrated in Fig. 4A or may generate control signals P_CLK for the respective pixels as illustrated in Fig. 4B. In the case where the pulse signal P_CLK is generated in common, at least one of an exposure-period control signal P_EXP, the cycle of the pulse signal, the number of pulses, and a pulse width is generated in common so as to correspond to an exposure period. In the case where the control signals P_CLK are controlled for the respective pixels, the signals can be generated by using the exposure-period control signal P_EXP and an input signal P_CLK_IN outputted from the control-pulse generating unit 115. Preferably, the control-pulse generating unit 115 includes, for example, a frequency divider circuit. This enables control to be simply implemented and inhibits the number of elements from increasing.

Signals that are outputted from the photoelectric conversion elements 102 of the pixels are processed by the signal processing circuits 103. Each signal processing circuit 103 includes a counter, a memory, and so on, and a digital value is held in the memory.

The horizontal scanning circuit unit 111 inputs control pulses for sequentially selecting columns into the signal processing circuits 103 in order to read, from the memories of the pixels in which digital signals are held, the signals.

Regarding a selected column, a signal is outputted from the signal processing circuit 103 of a pixel that is selected by the vertical scanning circuit unit 110 to the signal line 113.

The signal that is outputted to the signal line 113 is outputted to an external recording unit or a signal processing unit outside the photoelectric conversion apparatus 100 via an output circuit 114.

In Fig. 2, the array of the photoelectric conversion elements in the pixel region may be arranged in one dimension. The effects of the present invention can be achieved even with a single pixel. The case of a single pixel is included in the present invention. However, the photoelectric conversion apparatus that includes the multiple pixels is likely to achieve the effect of reducing power consumption according to the present embodiment. All of the photoelectric conversion elements do not necessarily have the function of a signal processing unit, but for example, multiple photoelectric conversion elements may share a single signal processing unit and may sequentially perform signal processing.

As illustrated in Fig. 2 and Fig. 3, the multiple signal processing circuits 103 are arranged in a region that overlaps the pixel region 12 in plan view. The vertical scanning circuit unit 110, the horizontal scanning circuit unit 111, the reading circuit 112, the output circuit 114, and the control-pulse generating unit 115 are provided so as to overlap a region between the periphery of the sensor substrate 11 and the periphery of the pixel region 12 in plan view. In other words, the sensor substrate 11 has the pixel region 12 and a non-pixel region located around the pixel region 12. The vertical scanning circuit unit 110, the horizontal scanning circuit unit 111, the reading circuit 112, the output circuit 114, and the control-pulse generating unit 115 are arranged in the region that overlaps the non-pixel region in plan view.

The arrangement of the signal lines 113 and the arrangements of the reading circuit 112 and the output circuit 114 are not limited to those in Fig. 3. For example, the signal lines 113 may extend in a row direction, and the reading circuit 112 may be disposed in a region to which the signal lines 113 extend.

Fig. 4A and Fig. 4B illustrate examples of a block diagram including equivalent circuits of Fig. 2 and Fig. 3. Fig. 4A illustrates an example in which the signal generating unit 215 is provided in common for the multiple pixels. Fig. 4B illustrates an example in which control signals P_CLK can be controlled for the respective pixels.

In Fig. 4A and Fig. 4B, a photoelectric conversion element 102 including an APD 201 is provided on the sensor substrate 11, and the other components are provided on the circuit substrate 21.

The APD 201 generates a pair of electric charges depending on incident light by using photoelectric conversion. A first node of two nodes of the APD 201 is connected to a control line (a second power supply) to which a drive voltage VL (a second voltage) is applied. A second node of the two nodes of the APD 201 is connected to a control line (a first power supply) to which a drive voltage VH (a first voltage) higher than the voltage VL that is applied to the anode is applied. In Fig. 4A and Fig. 4B, the first node of the APD 201 is the anode, and the second node of the APD is the cathode. A reverse bias voltage for the APD 201 to cause avalanche multiplication to occur is applied to the anode and cathode of the APD 201. With the voltages applied, an electric charge that is generated by the incident light causes the avalanche multiplication to occur, and an avalanche current is generated.

In the case where the reverse bias voltage is applied, an APD operates in a Geiger-mode in which an electric potential difference between the anode and the cathode is greater than a breakdown voltage, or in a linear mode in which the electric potential difference between the anode and the cathode is close to, equal to, or less than the breakdown voltage.

An APD that operates in the Geiger-mode is referred to as a SPAD. For example, the voltage VL (the second voltage) is -30 V, and the voltage VH (the first voltage) is 1 V. The APD 201 may operate in the linear mode or may operate in the Geiger-mode. In the case of the SPAD, the electric potential difference is greater than that of the APD in the linear mode, the effect of withstanding voltage becomes prominent, and accordingly, the SPAD is preferable.

A switch 202 is connected to the control line to which the drive voltage VH is applied and the APD 201. The switch 202 is connected to a node that is the anode or the cathode of the APD. As for the electric potential difference between the anode and cathode of the APD, the switch 202 switches between a first electric potential difference that causes the avalanche multiplication to occur and a second electric potential difference that does not cause the avalanche multiplication to occur. In the following description, switching from the second electric potential difference to the first electric potential difference is referred to as turning on the switch 202, and switching from the first electric potential difference to the second electric potential difference is referred to as turning off the switch 202. The switch 202 functions as a quenching element. The switch 202 functions as a load circuit (a quenching circuit) during signal multiplication due to the avalanche multiplication, reduces a voltage that is applied to the APD 201, and inhibits the avalanche multiplication (quenching operation). The switch 202 returns the voltage that is applied to the APD 201 to the drive voltage VH by allowing an electric current corresponding to a voltage drop due to the quenching operation (recharge operation) to flow. That is, the switch 202 functions as a control circuit that controls the occurrence of the avalanche multiplication in the APD 201.

For example, the switch 202 can include a MOS transistor. In the cases illustrated in Fig. 4A and Fig. 4B, the switch 202 is a PMOS transistor. The control signal P_CLK of the switch 202 that is supplied from the signal generating unit 215 is supplied to a gate electrode of the MOS transistor that is included in the switch 202. According to the present embodiment, a voltage that is applied to the gate electrode of the switch 202 is controlled, and consequently, the turning on and off of the switch 202 is controlled.

Each signal processing circuit 103 includes a waveform shaping unit 210, a counter circuit 211, and a selection circuit 212. Although each signal processing circuit 103 includes the waveform shaping unit 210, the counter circuit 211, and the selection circuit 212 in Fig. 4A and Fig. 4B, in the present specification, it is only necessary for each signal processing circuit 103 to include at least one of the waveform shaping unit 210, the counter circuit 211, and the selection circuit 212.

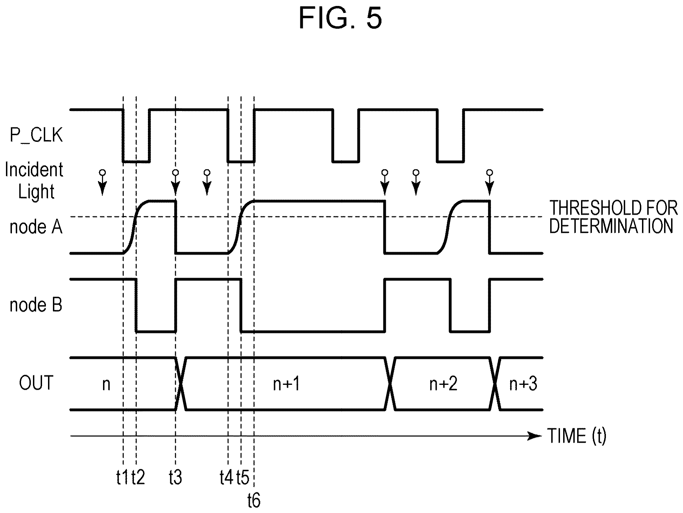

The waveform shaping unit 210 shapes a change in the electric potential of the cathode of the APD 201 that is acquired when a photon is detected, and outputs a pulse signal. An input node of the waveform shaping unit 210 is referred to as a node A, and an output node is referred to as a node B. The waveform shaping unit 210 changes an output electric potential from the node B depending on whether an input electric potential into the node A is equal to or more than or less than a predetermined value. For example, in Fig. 5, when the input electric potential into the node A is a high electric potential equal to or more than a threshold for determination, the output electric potential from the node B is at a low level. When the input electric potential into the node A is a low electric potential less than a threshold for determination, the output electric potential from the node B is at a high level. For example, an inverter circuit is used as the waveform shaping unit 210. In the examples illustrated in Fig. 4A and Fig. 4B, a single inverter is used as the waveform shaping unit 210, but a circuit acquired by connecting multiple inverters in series may be used, or another circuit that has a waveform shaping effect may be used.

The quenching operation and the recharge operation can be performed by using the switch 202 in response to the avalanche multiplication in the APD 201. In some cases, however, no output signal is determined depending on a photon detection timing. For example, suppose that the avalanche multiplication occurs in the APD, the node A falls to a low level, and the recharge operation is performed. The threshold for determination of the waveform shaping unit 210 is typically set at an electric potential higher than the electric potential difference when the avalanche multiplication occurs in the APD. If a photon is incident when the electric potential of the node A is lower than the threshold for determination due to the recharge operation, and the electric potential enables the avalanche multiplication to occur in the APD, the avalanche multiplication to occur in the APD, and the voltage of the node A is reduced. That is, the electric potential of the node A drops at a voltage lower than the threshold for determination, and accordingly, the output electric potential from the node B does not change regardless of detection of the photon. Accordingly, no signal is determined even when the avalanche multiplication occurs. In particular, under high luminance, photons continuously enter in a short period, and accordingly, a signal is unlikely to be determined. Consequently, the actual number of incident photons and outputted signals are likely to diverge from each other regardless of high luminance.

In contrast, a signal can be determined in a manner in which the control signal P_CLK is supplied to the switch 202, and the on state and off state of the switch 202 are switched, even in the case where photons continuously enter the APD in a short time. Fig. 5 illustrates an example in which the control signal P_CLK is a pulse signal that has a repeating cycle. In other words, in an aspect illustrated in Fig. 5, the on state and off state of the switch 202 are switched at a predetermined clock frequency. However, the effect of inhibiting the power consumption of the photoelectric conversion apparatus from increasing can be achieved even when the pulse signal does not have a repeating cycle.

The counter circuit 211 counts the pulse signal that is outputted from the waveform shaping unit 210 and holds a count value. When a control pulse pRES is supplied via a drive line 213, a signal that is held by the counter circuit 211 is reset.

A control pulse pSEL is supplied from the vertical scanning circuit unit 110 in Fig. 3 to the selection circuit 212 via a drive line 214 (not illustrated in Fig. 3) in Fig. 4A and Fig. 4B, and electrical connection and disconnection between the counter circuit 211 and the signal lines 113 are switched. For example, the selection circuit 212 includes a buffer circuit for outputting a signal. An output signal OUT illustrated in Fig. 4A and Fig. 4B is outputted from a pixel.

A switch such as a transistor may be disposed between the switch 202 and the APD 201 or between the photoelectric conversion element 102 and the signal processing circuit 103, and electrical connection may be switched. Similarly, the application of the voltage VH or the voltage VL that is supplied to the photoelectric conversion element 102 may be electrically switched by using a switch such as a transistor.

As for the structure described according to the present embodiment, the counter circuit 211 is used. However, the photoelectric conversion apparatus 100 may be configured such that a pulse detection timing is acquired by using a time-to-digital converter (TDC) and a memory instead of the counter circuit 211. At this time, the timing of generation of the pulse signal to be outputted from the waveform shaping unit 210 is converted into a digital signal by the TDC. A control pulse pREF (a reference signal) for measuring the timing of the pulse signal is supplied from the vertical scanning circuit unit 110 in Fig. 1 to the TDC via a drive line. The TDC acquires, as a digital signal, a signal when the timing of input of the signal that is outputted from each pixel via the waveform shaping unit 210 is a relative time, based on the control pulse pREF.

As illustrated in Fig. 4B, signal generating units 215 may be provided for the respective pixels. In Fig. 4B, an illustration for a circuit downstream of the waveform shaping unit 210 illustrated in Fig. 4A and the signal generating units is omitted. Suppose that in Fig. 4A, the signal generating units 215 are provided for the respective pixels. In Fig. 4B, a logic circuit is provided in the pixel, and whether a pulse signal is supplied to the switch 202 is determined. The input signal P_CLK_IN for controlling the control signal P_CLK and the exposure-period control signal P_EXP are inputted into the logic circuit. An inverted signal is outputted. For example, in the case where the exposure-period control signal P_EXP is at a low level, and the input signal P_CLK_IN is at a low level, a high-level signal is outputted from the control signal P_CLK. That is, the switch is turned off. In the case where the exposure-period control signal P_EXP is at a high level, and the input signal P_CLK_IN is at a high level, a low-level signal is outputted from the control signal P_CLK. That is, the switch is turned on. In the case where the exposure-period control signal P_EXP or the input signal P_CLK_IN is at a low level, a high-level signal is outputted as the control signal P_CLK. That is, the switch 202 is turned off. It is preferable that the switch be thus controlled for each pixel. In the case where a circuit diagram in Fig. 4B is used, when an exposure period P is at a low level, the control signal P_CLK is maintained at a high level as described according to a second embodiment described later. That is, the switch is turned off.

Fig. 5 schematically illustrates a relationship among the control signal P_CLK of the switch, the electric potential of the node A, the electric potential of the node B, and the output signal. According to the present embodiment, in the case where the control signal P_CLK is at a high level, the drive voltage VH is unlikely to be applied to the APD, and in the case where the control signal P_CLK is at a low level, the drive voltage VH is applied to the APD. For example, the high level of the control signal P_CLK is 1 V. For example, the low level of the control signal P_CLK is 0 V. In the case where the control signal P_CLK is at a high level, the switch is turned off. In the case where the control signal P_CLK is at a low level, the switch is turned on. The resistance value of the switch in the case where the control signal P_CLK is at a high level is larger than the resistance value of the switch in the case where the control signal P_CLK is at a low level. In the case where the control signal P_CLK is at a high level, the recharge operation is unlikely to be performed even when the avalanche multiplication occurs in the APD, and accordingly, an electric potential that is applied to the APD is equal to or less than the breakdown voltage of the APD. Accordingly, the avalanche multiplication in the APD stops.

As illustrated in Fig. 4A and Fig. 4B, the switch 202 preferably includes a single transistor, and the transistor performs the quenching operation and the recharge operation. This enables the number of circuits to be decreased unlike the case where the quenching operation and the recharge operation are performed by using respective different circuit elements. In particular, in the case where each pixel includes a counter circuit, and the signal of the SPAD is read for each pixel, a circuit area used for the switch in order to dispose the counter circuit is preferably reduced, and the switch 202 that includes the single transistor exerts the pronounced effect.

At time t1, the control signal P_CLK changes from a high level to a low level, the switch is turned on, and the recharge operation of the APD starts. Consequently, the electric potential of the cathode of the APD changes to a high level. An electric potential difference between electric potentials applied to the anode and cathode of the APD results in a state in which the avalanche multiplication can occur. The electric potential of the cathode is equal to that of the node A. Accordingly, when the electric potential of the cathode transitions to the high level from a low level, the electric potential of the node A is equal to or more than a threshold for determination at time t2. At this time, the pulse signal that is outputted from the node B is inverted and transitions to a low level from a high level. Subsequently, an electric potential difference between the drive voltage VH and the drive voltage VL is applied to the APD 201. The control signal P_CLK is at a high level, and the switch is turned off.

Subsequently, if a photon enters the APD 201 at time t3, the avalanche multiplication occurs in the APD 201, and the voltage of the cathode drops. That is, the voltage of the node A drops. When the amount of voltage drop further increases, and a voltage difference applied to the APD 201 decreases, the avalanche multiplication in the APD 201 stops as illustrated at time t2, and the voltage level of the node A does not drop by a certain value or more. If the voltage of the node A becomes lower than the threshold for determination while the voltage of the node A drops, the voltage of the node B changes from a low level to a high level. That is, a portion of the output waveform of the node A exceeding the threshold for determination is waveform-shaped by the waveform shaping unit 210 and is outputted as a signal at the node B. The count value of a counter signal that is outputted from the counter circuit increases by 1 LSB by being counted by the counter circuit.

Although a photon enters the APD at time between time t3 and time t4, the switch is off, the voltage that is applied to the APD 201 does not correspond to an electric potential difference that causes the avalanche multiplication to occur, and accordingly, the voltage level of the node A does not exceed the threshold for determination.

At time t4, the control signal P_CLK changes from a high level to a low level, and the switch is turned on. As a result, an electric current for compensating the drive voltage VH for the voltage drop flows through the node A, and the voltage of the node A transitions to the original voltage level. In this case, the voltage of the node A is equal to or more than the threshold for determination at time t5, and accordingly, the pulse signal of the node B is inverted and changes from a high level to a low level.

At time t6, the node A settles to the original voltage level, and the control signal P_CLK changes from a low level to a high level. Accordingly, the switch is turned off. Thereafter, the electric potentials of each node and the signal line, for example, change depending on the control signal P_CLK and the incident photons as described for time t1 to time t6.

Photoelectric conversion apparatuses according to embodiments will hereinafter be described.

### <First Embodiment>

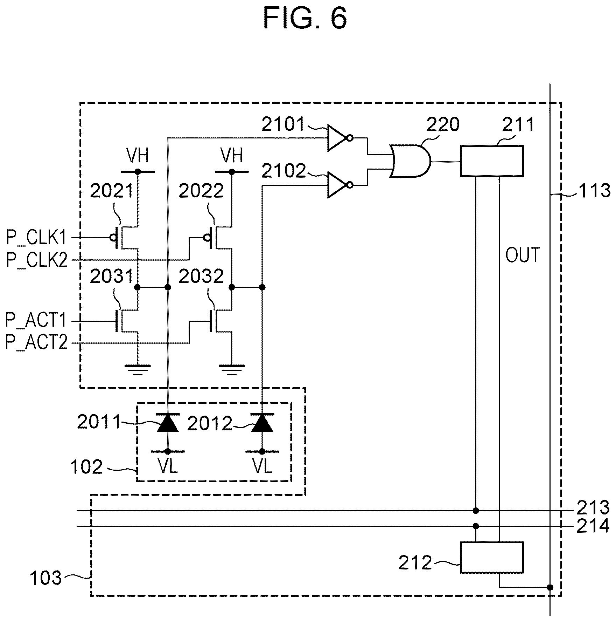

The structure of a photoelectric conversion apparatus according to a first embodiment and a method of driving the photoelectric conversion apparatus will be described with reference to Fig. 6 to Fig. 7B. In the following description, like components are designated by using like reference signs, and the description thereof is omitted or simplified.

Fig. 6 illustrates an example of the structure of a photoelectric conversion element 102 and a signal processing circuit 103 according to the first embodiment.

In Fig. 6, the photoelectric conversion element 102 includes an APD 2011 (a first avalanche photodiode) and an APD 2012 (a second avalanche photodiode).

The APD 2011 and the APD 2012 generate a pair of electric charges depending on incident light by using photoelectric conversion. A first node of two nodes of each of the APD 2011 and the APD 2012 is connected to a control line to which the drive voltage VL (the second voltage) is applied. A second node of the two nodes of each of the APD 2011 and the APD 2012 is connected to a control line to which the drive voltage VH (the first voltage) higher than the voltage VL that is applied to the anode is applied. A reverse bias voltage for the APD 2011 and the APD 2012 to cause the avalanche multiplication to occur is applied to the anodes and cathodes of the APD 2011 and the APD 2012. With the voltages applied, the avalanche multiplication occurs due to an electric charge that is generated by the incident light, and an avalanche current is generated.

A PMOS transistor 2021 (a first switch) that serves as a switch is connected to a control line (a first power supply) to which a drive voltage is applied and a first terminal of the APD 2011. Similarly, a PMOS transistor 2022 (a third switch) is connected to the control line to which a drive voltage is applied and a first terminal of the APD 2012. The PMOS transistor 2021 is connected to the cathode of the APD 2011, and the PMOS transistor 2022 is connected to the cathode of the APD 2012.

The PMOS transistor 2021 and the PMOS transistor 2022 function as quenching elements. The PMOS transistor 2021 functions as a load circuit (a quenching circuit) during signal multiplication due to the avalanche multiplication, reduces the voltage that is applied to the APD 2011, and inhibits the avalanche multiplication (quenching operation). The PMOS transistor 2022 functions as a load circuit during the signal multiplication due to the avalanche multiplication, reduces the voltage that is applied to the APD 2012, and inhibits the avalanche multiplication. In addition, the PMOS transistor 2021 returns the voltage that is applied to the APD 2011 to the drive voltage VH by allowing an electric current corresponding to a voltage drop due to the quenching operation (recharge operation) to flow. The PMOS transistor 2022 returns the voltage that is applied to the APD 2012 to the drive voltage VH.

The control signal P_CLK1 of the PMOS transistor 2021 that is supplied from the signal generating unit 215, not illustrated, is supplied to a gate electrode of the PMOS transistor 2021. The control signal P_CLK2 of the PMOS transistor 2022 is supplied to a gate electrode of the PMOS transistor 2022. According to the first embodiment, the voltages that are applied to the gate electrodes of the PMOS transistor 2021 and the PMOS transistor 2022 are controlled, and consequently, turning on and off of the PMOS transistor 2021 and the PMOS transistor 2022 that serve as switches is controlled.

The drain of an NMOS transistor 2031 (a second switch) that serves as a switch is connected to the cathode that is the second terminal of the APD 2011, and the source of the NMOS transistor 2031 is grounded. The drain of an NMOS transistor 2032 (a fourth switch) is connected to the cathode of the APD 2012, and the source of the NMOS transistor 2032 is grounded. In other words, a third voltage is applied from a third power supply to the NMOS transistor 2031 and the NMOS transistor 2032.

The PMOS transistor 2021 and the NMOS transistor 2031 are connected to the APD 2011. As for the electric potential difference between the anode and cathode of the APD 2011, each MOS transistor switches between the first electric potential difference that causes the avalanche multiplication to occur and the second electric potential difference that does not cause the avalanche multiplication to occur. For example, the voltage VL (the second voltage) is -30 V, the voltage VH (the first voltage) is 1 V, and the breakdown voltage of the APD 2011 is 30.5 V. In the case where the PMOS transistor 2021 is on, and the NMOS transistor 2031 is off, the reverse bias voltage that is applied to the APD 2011 satisfies VH - VL = 31 V and is higher than 30.5 V equal to the breakdown voltage, and accordingly, the APD 2011 causes the avalanche multiplication to occur. In this case, the first electric potential difference is 31 V. In the case where the PMOS transistor 2021 is off, and the NMOS transistor 2031 is on, the reverse bias voltage that is applied to the APD 2011 satisfies 0 - VL = 30 V and is lower than 30.5 V equal to the breakdown voltage. For this reason, the APD 2011 does not cause the avalanche multiplication to occur. In this case, the second electric potential difference is 30 V.

If the PMOS transistor 2021 and the NMOS transistor 2031 are simultaneously turned on, the PMOS transistor 2021 and the NMOS transistor 2031 are short-circuited and generate a shoot-through current. The same is true for when the PMOS transistor 2022 and the NMOS transistor 2032 are simultaneously turned on. In view of this, the PMOS transistor 2021 and the NMOS transistor 2031 are controlled so as not to be simultaneously turned on. Alternatively, it is necessary to provide another switch between a voltage application wiring line and the PMOS transistor 2021 or the NMOS transistor 2031 such that the shoot-through current does not flow. The PMOS transistor 2022 and the NMOS transistor 2032 are controlled in the same manner.

Similarly, the PMOS transistor 2022 and the NMOS transistor 2032 are connected to the APD 2012. As for the electric potential difference between the anode and cathode of the APD 2012, each MOS transistor switches between the first electric potential difference that causes the avalanche multiplication to occur and the second electric potential difference that does not cause the avalanche multiplication to occur.

The control signal P_ACT1 of the NMOS transistor 2031 to be supplied from the signal generating unit 215, not illustrated, is supplied to a gate electrode of the NMOS transistor 2031. According to the first embodiment, the voltage that is applied to the gate electrode of the NMOS transistor 2031 is controlled, and consequently, turning on and off of the NMOS transistor 2031 that serves as a switch is controlled. Similarly, the control signal P_ACT2 of the NMOS transistor 2032 is supplied to a gate electrode of the NMOS transistor 2032.

An inactive state described below in some cases refers to a state in which the NMOS transistor 2031 is turned on due to the control signal P_ACT1, and the electric potential difference between the anode and cathode of the APD 2011 is equal to the second electric potential difference that does not cause the avalanche multiplication to occur. An active state described below in some cases refers to a state in which the NMOS transistor 2031 is turned off due to the control signal P_ACT1, and the electric potential difference between the anode and cathode of the APD 2011 is equal to the first electric potential difference that causes the avalanche multiplication to occur.

Similarly, the inactive state described below in some cases also refers to a state in which the NMOS transistor 2032 is turned on due to the control signal P_ACT2, and the electric potential difference between the anode and cathode of the APD 2012 is equal to the second electric potential difference that does not cause the avalanche multiplication to occur. The active state described below in some cases also refers to a state in which the NMOS transistor 2032 is turned off due to the control signal P_ACT2, and the electric potential difference between the anode and cathode of the APD 2012 is equal to the first electric potential difference that causes the avalanche multiplication to occur.

The signal processing circuit 103 includes a waveform shaping unit 2101, a waveform shaping unit 2102, the counter circuit 211, the selection circuit 212, and an OR circuit 220.

The waveform shaping unit 2101 shapes a change in the electric potential of the cathode of the APD 2011 that is acquired when a photon is detected, and outputs a pulse signal. The waveform shaping unit 2102 shapes a change in the electric potential of the cathode of the APD 2012 that is acquired when a photon is detected and outputs a pulse signal. For example, inverter circuits are used as the waveform shaping unit 2101 (a first pulse generating circuit) and the waveform shaping unit 2102 (a second pulse generating circuit). In an example illustrated in Fig. 6, a single inverter is used as each of the waveform shaping unit 2101 and the waveform shaping unit 2102, but a circuit acquired by connecting multiple inverters in series may be used, or another circuit that has a waveform shaping effect may be used.

The OR circuit 220 collectively outputs the first pulse signal that is outputted from the waveform shaping unit 2101 and the second pulse signal that is outputted from the waveform shaping unit 2102 to the counter circuit 211. Consequently, the counter circuit 211 counts the total number of photons that are detected by the APD 2011 and the APD 2012.

The counter circuit 211 counts a pulse signal that is outputted from the OR circuit 220 and holds a count value.

The APD 2011, the PMOS transistor 2021, the NMOS transistor 2031, and the waveform shaping unit 2101 are defined as a first pixel element. The APD 2012, the PMOS transistor 2022, the NMOS transistor 2032, and the waveform shaping unit 2102 are defined as a second pixel element. An example of the structure in Fig. 6 includes the two pixel elements, but the number of the pixel elements may be 3 or more and is not particularly limited.

A method of driving the photoelectric conversion apparatus according to the first embodiment will now be described by using the structure in Fig. 6 as an example.

In the case where the photoelectric conversion element 102 includes only a single APD, as illustrated in Fig. 4A and Fig. 4B, a single electrode collects all electric charges, the avalanche multiplication occurs, and this can degrade device characteristics dependent on the avalanche multiplication. In view of this, as illustrated in Fig. 6, the photoelectric conversion element 102 includes two or more APDs, the APDs are alternately or periodically put into the active state, and consequently, the device characteristics can be inhibited from being degraded.

In the case where the photoelectric conversion element 102 includes the two APDs as illustrated in Fig. 6, the frequency of the avalanche multiplication of each APD is about 1/2 of the frequency in the case where only a single APD is included, and accordingly, the device characteristics can be inhibited from being degraded by about a factor of two. In a case considered herein, the photoelectric conversion element 102 further includes a third avalanche photodiode as a component not illustrated. In the case where the photoelectric conversion element 102 includes three APDs, the frequency of the avalanche multiplication of each APD is about 1/3 of the frequency in the case where only a single APD is included, and accordingly, the device characteristics can be inhibited from being degraded by about a factor of three. That is, the more the number of APDs that are included in the photoelectric conversion element 102, the greater the effect of inhibiting the device characteristics from being degraded.

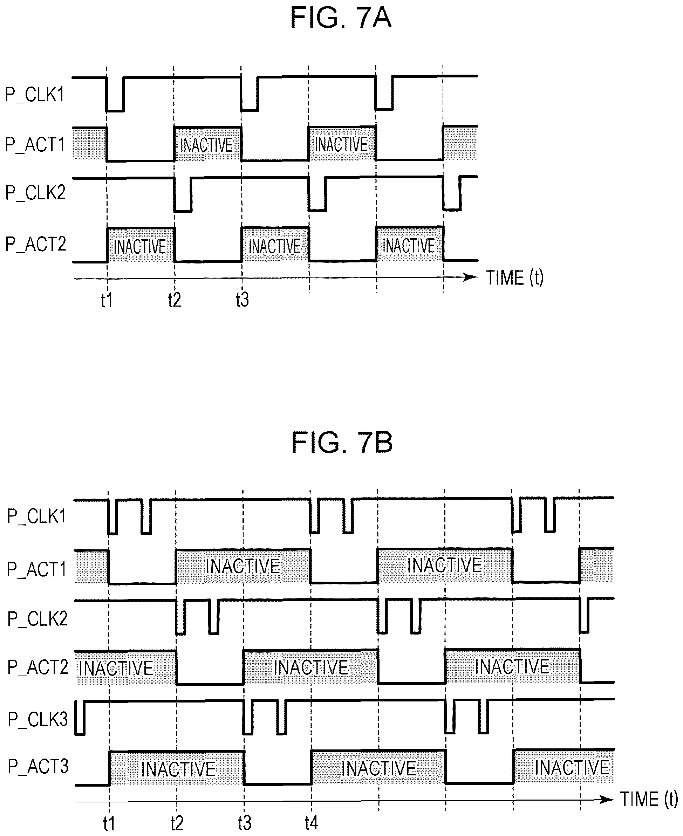

Fig. 7A and Fig. 7B are timing charts illustrating the operation of the signal processing circuit 103 according to the first embodiment.

Fig. 7A is the timing chart in the case where the photoelectric conversion element 102 includes the two APDs 2011 and 2012. When the control signal P_CLK1 is at a low level, the PMOS transistor 2021 is turned on. When the control signal P_CLK2 is at a low level, the PMOS transistor 2022 is turned on. When the control signal P_ACT1 is at a high level, the NMOS transistor 2031 is turned on. When the control signal P_ACT2 is at a high level, the NMOS transistor 2032 is turned on. For example, the meaning of the control signal P_CLK1, the control signal P_CLK2, the control signal P_ACT1, and the control signal P_ACT2 being at a high level is that each signal is 1 V. For example, the meaning of the control signal P_CLK1, the control signal P_CLK2, the control signal P_ACT1, and the control signal P_ACT2 being at a low level is that each signal is 0 V.

In the case where the control signal P_CLK1 and the control signal P_CLK2 are at a low level, the drive voltage VH is applied to the APD 2011 and the APD 2012, and the recharge operation is performed. In the case where the control signal P_ACT1 and the control signal P_ACT2 are at a high level, a ground voltage is applied to the APD 2011 and the APD 2012, and these are in the inactive state.

In Fig. 7A, during a period from time t1 to time t2, the control signal P_ACT1 is at a low level, and the APD 2011 is in the active state. The control signal P_CLK1 is inputted for one cycle, and a single photon can be counted during this period. In contrast, the control signal P_ACT2 is at a high level, and the APD 2012 is in the inactive state.

During a period from time t2 to time t3, the control signal P_ACT2 is at a low level, and the APD 2012 is in the active state. The control signal P_CLK2 is inputted for one cycle, and a single photon can be counted during this period. The control signal P_ACT1 is at a high level, and the APD 2011 is in the inactive state.

Thereafter, the APD 2011 and the APD 2012 are alternately put into the active state by using the control signal P_ACT1 and the control signal P_ACT2, and consequently, the device characteristics can be inhibited from being degraded.

If the PMOS transistor 2021 and the NMOS transistor 2031 are simultaneously turned on, the PMOS transistor 2021 and the NMOS transistor 2031 are short-circuited and generate a shoot-through current. For this reason, the period during which the control signal P_CLK1 is at a low level is controlled so as not to overlap the period during which the control signal P_ACT1 is at a high level.

At time t1, the control signal P_ACT1 is transitioned to a low level, the NMOS transistor 2031 is turned off, and the APD 2011 is put into the active state. The control signal P_CLK1 is synchronously transitioned to a low level, and consequently, the APD 2011 performs the recharge operation.

At time t2, the control signal P_ACT1 is transitioned to a high level, the NMOS transistor 2031 is turned on, the APD 2011 is put into the inactive state, and the control signal P_CLK1 is not changed from a high level.

At time t3 onward, the same control is repeated such that the period during which the control signal P_CLK1 is at a low level does not overlap the period during which the control signal P_ACT1 is at a high level.

Similarly, if the PMOS transistor 2022 and the NMOS transistor 2032 are simultaneously turned on, the PMOS transistor 2022 and the NMOS transistor 2032 are short-circuited and generate a shoot-through current. For this reason, the period during which the control signal P_CLK2 is at a low level is controlled so as not to overlap the period during which the control signal P_ACT2 is at a high level.

At time t1, the control signal P_ACT2 is transitioned to a high level, the NMOS transistor 2032 is turned on, the APD 2012 is put into the inactive state, and the control signal P_CLK2 is not changed from a high level.

At time t2, the control signal P_ACT2 is transitioned to a low level, the NMOS transistor 2032 is turned off, and the APD 2012 is put into the active state. The control signal P_CLK2 is synchronously transitioned to a low level, and consequently, the APD 2012 performs the recharge operation.

At time t3 onward, the same control is repeated such that the period during which the control signal P_CLK2 is at a low level does not overlap the period during which the control signal P_ACT2 is at a high level. In other words, control is periodically implemented such that after the first period during which the APD 2011 is in a standby state and in the active state, the second period during which the APD 2012 is in the standby state and in the active state starts, and the first period starts again after the second period.

Fig. 7B is a timing chart in the case where the photoelectric conversion element 102 includes three APDs, and the control signal P_CLK for two cycles is inputted in one active period.

During a period from time t1 to time t2 in Fig. 7B, the control signal P_ACT1 is at a low level, and the APD that is connected to the NMOS transistor controlled by using the control signal P_ACT1 is in the active state. The control signal P_CLK1 for two cycles is inputted, and two photons can be counted during this period. The control signals P_ACT2 and 3 are at a high level, and each APD that is connected to the NMOS transistor controlled by using the control signals P_ACT2 and 3 is in the inactive state.

During a period from time t2 to time t3, the control signal P_ACT2 is at a low level, and the APD that is connected to the NMOS transistor controlled by using the control signal P_ACT2 is in the active state. The control signal P_CLK2 for two cycles is inputted, and two photons can be counted during this period. The control signals P_ACT1 and 3 are at a high level, each APD that is connected to the NMOS transistor controlled by using the control signals P_ACT1 and 3 is in the inactive state.

During a period from time t3 to time t4, the control signal P_ACT3 is at a low level, and the APD that is connected to the NMOS transistor controlled by using the control signal P_ACT3 is in the active state. The control signal P_CLK3 for two cycles is inputted, and two photons can be counted during this period. The control signals P_ACT1 and 2 are at a high level, and each APD that is connected to the NMOS transistor controlled by using the control signals P_ACT1 and 2 is in the inactive state.

Thereafter, each APD is periodically put into the active state by using the control signals P_ACT1, 2, and 3, and consequently, the device characteristics can be inhibited from being degraded. The order of putting into the active state may be the order of the control signal P_ACT1, the control signal P_ACT2, and the control signal P_ACT3 or the order of the control signal P_ACT1, the control signal P_ACT3, and the control signal P_ACT2.

As illustrated in Fig. 7B, the number of the pixel elements according to the first embodiment may be 3 or more and is not particularly limited. The number of cycles of the control signal P_CLK that is inputted during one active period may be one cycle, or two or more cycles.

According to the first embodiment described above, the photoelectric conversion element 102 includes two or more APDs, the APDs are alternately or periodically put into the active state, and consequently, the device characteristics can be inhibited from being degraded.

### <Second Embodiment>

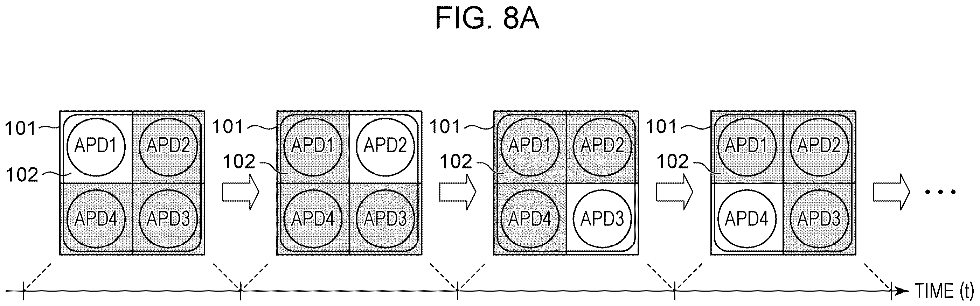

The structure of a photoelectric conversion apparatus according to a second embodiment and a method of driving the photoelectric conversion apparatus will be described with reference to Fig. 8A to Fig. 12. In the following description, like components are designated by using like reference signs, and the description thereof is omitted in some cases.

As for the photoelectric conversion apparatus described according to the first embodiment, each photoelectric conversion element 102 includes two or more APDs, and the APDs are alternately or periodically put into the active state. In this case, light incident on a region in which an APD in the inactive state is present cannot be detected, and accordingly, sensitivity is lower than that in the case where all APDs are always in the active state.

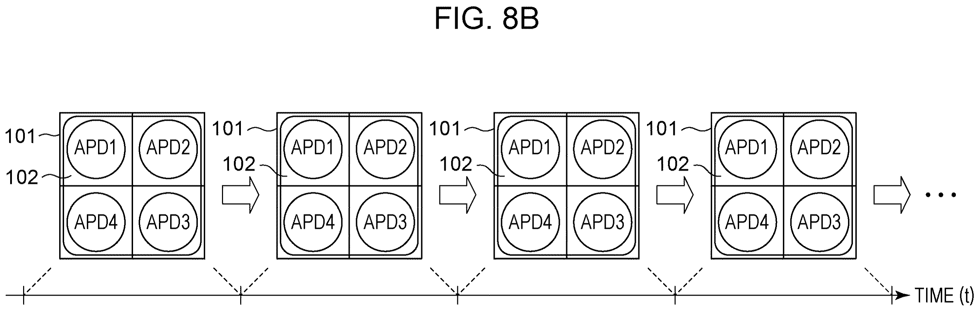

Fig. 8A and Fig. 8B are schematic diagrams illustrating a decrease in sensitivity in the case where each photoelectric conversion element 102 includes four APDs that are periodically put into the active state.

Fig. 8A is a plan view of a pixel 101 where APDs are periodically put into the active state in the order of an APD1, an APD2, an APD3, and an APD4 clockwise from the upper left APD. White regions represent active regions of the pixel 101, and gray regions represent inactive regions of the pixel 101. An electric charge that is photoelectrically converted in an inactive region does not cause the avalanche multiplication to occur and cannot be detected as a photon. That is, the sensitivity of the pixel 101 decreases to about 1/4 of that in the case where all of the four APDs are put into the active state.

Fig. 8B is a plan view of the pixel 101 where the APD1, the APD2, the APD3, and the APD4 are always in the active state. Since there are no inactive regions, the possibility of missing a photon is lower than that in the case of Fig. 8A, and the sensitivity is about 4 times that in the case where the four APDs are put into the active state one by one. In the case of Fig. 8B, power consumption due to the avalanche multiplication is about 4 times that in the case of Fig. 8A, and the rate of degradation of the device characteristics of the APDs is about 4 times.

A case where the structure in Fig. 6 is driven as illustrated in Fig. 8B will now be described. In a case considered herein, the APD 2011 and the APD 2012 are always in the active state, and the APD 2011 and the APD 2012 detect photons. The OR circuit 220 performs a logical operation on pulse signals that are outputted from the waveform shaping unit 2101 and the waveform shaping unit 2102 and outputs a signal to the counter circuit 211. For this reason, photons that are detected by the APDs are not counted in duplicate.

Fig. 8A and Fig. 8B are merely schematic diagrams, light incident on the active regions illustrated in white may entirely cause the avalanche multiplication to occur after being photoelectrically converted, and light incident on the inactive regions illustrated in gray may not cause the avalanche multiplication at all after being photoelectrically converted. In practice, the middle point of each APD is substantially a potential peak, and photons in a region surrounded by the peak gather to the APD and cause the avalanche multiplication to occur.

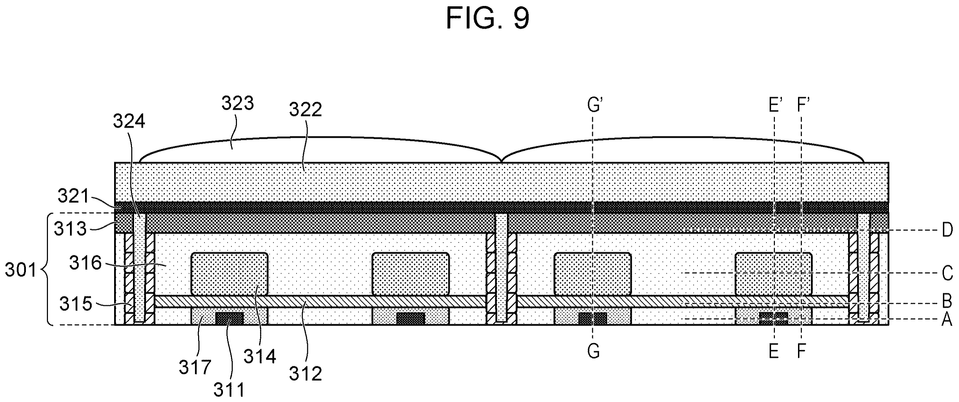

Fig. 9 is a sectional view of the photoelectric conversion elements 102 of two pixels of the photoelectric conversion apparatus according to the second embodiment, taken along a direction perpendicular to a surface direction of a substrate.

The structure and function of the photoelectric conversion elements 102 will be described. Each photoelectric conversion element 102 includes a first semiconductor region 311, a fourth semiconductor region 314, a sixth semiconductor region 316, and a seventh semiconductor region 317 of the N-type. A second semiconductor region 312, a third semiconductor region 313, and a fifth semiconductor region 315 of the P-type are also included.

According to the second embodiment, the first semiconductor region 311 of the N-type is formed near a surface opposite the light incident surface in the cross-section illustrated in Fig. 9, and the seventh semiconductor region 317 of the N-type is formed in the vicinity thereof. The second semiconductor region 312 of the P-type is formed so as to overlap the first semiconductor region 311 and the seventh semiconductor region 317 in plan view, and an APD is formed. The fourth semiconductor region 314 of the N-type is disposed so as to overlap the second semiconductor region 312 in plan view, and the sixth semiconductor region 316 of the N-type is formed in the vicinity thereof. In the cross-section illustrated in Fig. 9, cross-sections of two APDs are illustrated per photoelectric conversion element 102.

The N-type impurity concentration of the first semiconductor region 311 that forms the APD is higher than those of the fourth semiconductor region 314 and the seventh semiconductor region 317. A PN junction is formed between the second semiconductor region 312 of the P-type and the first semiconductor region 311 of the N-type. When the impurity concentration of the second semiconductor region 312 is lower than the impurity concentration of the first semiconductor region 311, the second semiconductor region 312 is entirely a depletion layer region. The depletion layer region extends to a portion of the first semiconductor region 311, and a strong electric field is induced in the extending depletion layer region. The strong electric field causes the avalanche multiplication to occur in the depletion layer region that extends in the portion of the first semiconductor region 311, and an electric current based on a multiplied electric charge is outputted as a signal charge. If light incident on the photoelectric conversion element 102 is photoelectrically converted, and the avalanche multiplication occurs in the depletion layer region, the generated electric charge of the first conductivity type is collected in the first semiconductor region 311.

In Fig. 9, the fourth semiconductor region 314 and the seventh semiconductor region 317 have approximately the same size, but the size of each semiconductor region is not limited thereto. For example, the fourth semiconductor region 314 may be larger than the seventh semiconductor region 317, and the electric charge may be collected in the first semiconductor region 311 from a wide range.

A pixel separation portion 324 that has a trench structure separates pixels of the photoelectric conversion elements from each other, and the fifth semiconductor region 315 of the P-type that is formed in the vicinity thereof separates the adjacent photoelectric conversion elements from each other by using a potential barrier. The photoelectric conversion elements are separated from each other also by the potential of the fifth semiconductor region 315, and accordingly, the trench structure of the pixel separation portion 324 is not essential for the pixel separation portion. When the pixel separation portion 324 is provided, the depth and position thereof are not limited to those in the structure in Fig. 9. The pixel separation portion 324 may be deep trench isolation (DTI) that extends through a semiconductor layer or DTI that does not extend through a semiconductor layer. Metal may be embedded in DTI in order to improve light-shielding performance. The pixel separation portion 324 may surround the entire periphery of a photoelectric conversion element in plan view or may be located, for example, on opposite sides of a photoelectric conversion element. An insulating isolation portion such as the trench structure is not provided between APDs that are provided in each pixel.

A pinning film 321, a flattening film 322, and a microlens 323 are formed on the light incident surface of a semiconductor layer. For example, a filter layer, not illustrated, may be disposed on the light incident surface. Various optical filters such as a color filter, an infrared-cut filter, and a monochrome filter can be used for the filter layer. Examples of the color filter can include an RGB color filter and an RGBW color filter.

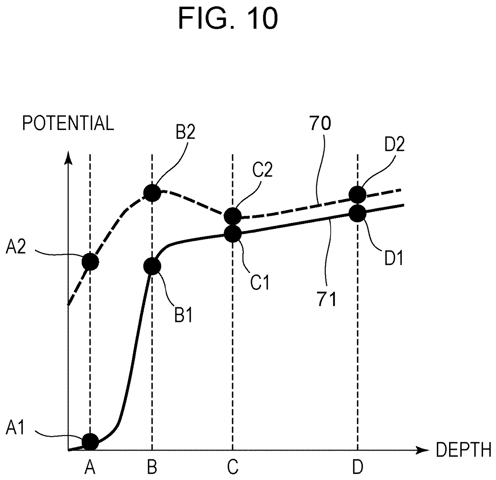

Fig. 10 is a potential diagram for each APD of the photoelectric conversion elements 102 illustrated in Fig. 9.

A dotted line 70 in Fig. 10 represents the potential distribution of line FF' in Fig. 9, and a solid line 71 in Fig. 10 represents the potential distribution of line EE' in Fig. 9. Fig. 10 illustrates a potential viewed from an electron that is a main carrier charge of the N-type semiconductor region. In the case where the main carrier charge is a hole, the relationship of the magnitude of the potential is reversed. A depth A in Fig. 10 corresponds to a height A in Fig. 9. Similarly, a depth B corresponds to a height B, a depth C corresponds to a height C, and a depth D corresponds to a height D.

In Fig. 10, the potential height of the solid line 71 at the depth A is A1, the potential height of the dotted line 70 at the depth A is A2, the potential height of the solid line 71 at the depth B is B1, and the potential height of the dotted line 70 at the depth B is B2. The potential height of the solid line 71 at the depth C is C1, the potential height of the dotted line 70 at the depth C is C2, the potential height of the solid line 71 at the depth D is D1, and the potential height of the dotted line 70 at the depth D is D2.

From Fig. 9 and Fig. 10, the potential height of the first semiconductor region 311 corresponds to A1, and the potential height near a central portion of the second semiconductor region 312 corresponds to B1. The potential height of the seventh semiconductor region 317 corresponds to A2, and the potential height at an outer edge portion of the second semiconductor region 312 corresponds to B2.

As for the dotted line 70 in Fig. 10, the potential gradually decreases from the depth D to the depth C. The potential gradually increases from the depth C to the depth B and is at a B2 level at the depth B. The potential decreases from the depth B to the depth A and is at an A2 level at the depth A.

As for the solid line 71, the potential gradually decreases from the depth D to the depth C and from the depth C to the depth B and is at a B1 level at the depth B. The potential sharply decreases from the depth B to the depth A, and the potential is at an A1 level at the depth A. At the depth D, the potentials of the dotted line 70 and the solid line 71 are at substantially the same height and have a potential gradient that gently decreases toward a second surface of a semiconductor layer 301 in a region illustrated by using line EE' and line FF'. For this reason, an electric charge that is generated in a light detection device moves toward the second surface with the gentle potential gradient.

As for an avalanche diode according to the second embodiment, the impurity concentration of the second semiconductor region 312 of the P-type is lower than that of the first semiconductor region 311 of the N-type, and a reverse-biased electric potential is applied to the first semiconductor region 311 and the second semiconductor region 312. Consequently, a depletion layer region is formed on a side of the second semiconductor region 312. With this structure, the second semiconductor region 312 serves as a potential barrier for a photoelectrically converted electric charge in the fourth semiconductor region 314, and consequently, the electric charge is likely to be collected in the first semiconductor region 311.

In Fig. 9, the second semiconductor region 312 is formed over the entire surface of each photoelectric conversion element. However, the second semiconductor region 312 may not be provided, for example, at a portion overlapping the first semiconductor region 311 in plan view, and a slit in which the fourth semiconductor region 314 extends may be formed. In this case, the potential decreases in a direction from line FF' to line EE' at the depth C in Fig. 9 due to a potential difference between the second semiconductor region 312 and a slit portion. This facilitates movement of the electric charge in the direction of the first semiconductor region 311 while a photoelectrically converted electric charge in the fourth semiconductor region 314 moves. In the case where the second semiconductor region 312 is formed over the entire surface as illustrated in Fig. 9, the voltage that is applied to acquire the strong electric field required for the avalanche multiplication can be reduced unlike the case where the slit is formed, and noise due to a strong electric field region that is locally formed can be reduced.

The electric charge that moves to the vicinity of the second semiconductor region 312 is accelerated by the sharp potential gradient of the solid line 71 from the depth B to the depth A in Fig. 10, that is, by the strong electric field, and consequently, the avalanche multiplication occurs.

In contrast, the potential distribution between the second semiconductor region 312 of the P-type and the seventh semiconductor region 317 in Fig. 9, that is, from the depth B to the depth A on the dotted line 70 in Fig. 10 does not cause the avalanche multiplication to occur. For this reason, the area of the strong electric field region (an avalanche multiplication region) with respect to the size of a photodiode may not be increased, and an electric charge that is generated in the fourth semiconductor region 314 can be counted as a signal charge. In the above description, the conductivity type of the seventh semiconductor region 317 is the N-type, but a P-type semiconductor region may be used provided that the concentration thereof satisfies the potential relationship described above.

A photoelectrically converted electric charge in the second semiconductor region 312 flows into the fourth semiconductor region 314 due to the potential gradient of the dotted line 70 from the depth B to the depth C in Fig. 10. The electric charge in the fourth semiconductor region 314 is likely to move to the second semiconductor region 312 for the reason described above. For this reason, the photoelectrically converted electric charge in the second semiconductor region 312 moves to the first semiconductor region 311 and is detected as a signal charge due to the avalanche multiplication. Accordingly, sensitivity to the photoelectrically converted electric charge in the second semiconductor region 312 is provided.

The dotted line 70 in Fig. 10 represents a cross-sectional potential along line FF' in Fig. 9. As for the dotted line 70, a point at which the height A and line FF' in Fig. 9 intersect is A2, a point at which the height B and line FF' intersect is B2, a point at which the height C and line FF' intersect is C2, and a point at which the height D and line FF' intersect is D2. A photoelectrically converted electron in the fourth semiconductor region 314 in Fig. 9 moves from a potential D2 to C2 in Fig. 10 but cannot cross C2 to B2 because this is a potential barrier for the electron. For this reason, the electron moves to a position near the center of the fourth semiconductor region 314 illustrated by using line EE' in Fig. 9. The moved electron moves from the potential gradient C1 to B1 in Fig. 10, causes the avalanche multiplication to occur due to the sharp potential gradient from B1 to A1, passes through the first semiconductor region 311, and is subsequently detected as a signal charge.

An electric charge that is generated near the boundary between the third semiconductor region 313 and the sixth semiconductor region 316 in Fig. 9 moves along the potential gradient from the potential B2 to C2 in Fig. 10. Subsequently, it moves to a position near the center of the fourth semiconductor region 314 illustrated by using line EE' in Fig. 9 as described above. The avalanche multiplication occurs due to the sharp potential gradient from B1 to A1. The electric charge that causes the avalanche multiplication to occur passes through the first semiconductor region 311 and is subsequently detected as a signal charge.

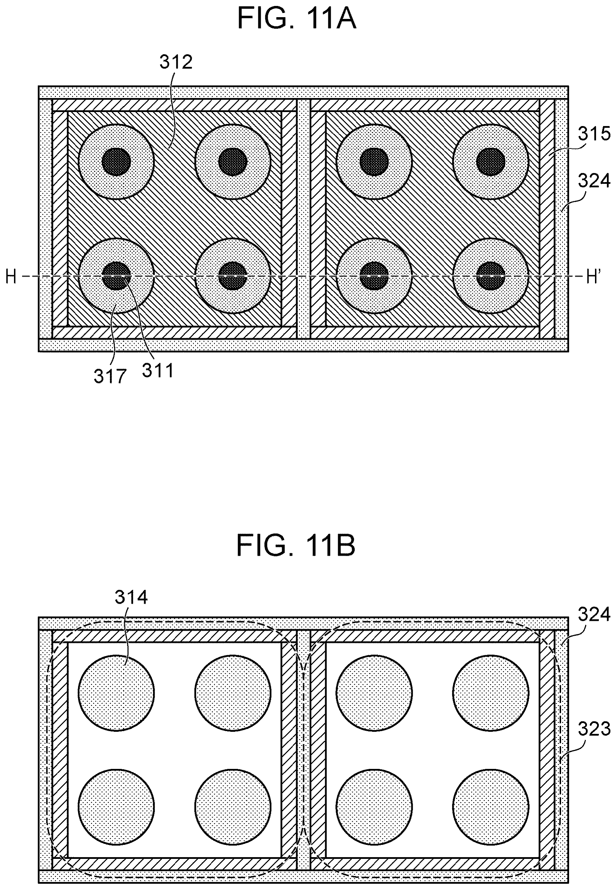

Fig. 11A and Fig. 11B are plan views of the photoelectric conversion elements 102 of two pixels of the photoelectric conversion apparatus according to the second embodiment. Fig. 11A is the plan view when viewed from a surface opposite the light incident surface. Fig. 11B is the plan view when viewed from the light incident surface. Fig. 9 can be said as a sectional view taken along line HH' in Fig. 11A.

In Fig. 11A and Fig. 11B, the first semiconductor region 311, the fourth semiconductor region 314, and the seventh semiconductor region 317 are circular and are concentric. With this structure, an electric field is inhibited from locally concentrating on an end portion in the strong electric field region between the first semiconductor region 311 and the second semiconductor region 312, and a DCR can be reduced. The shapes of the semiconductor regions are not limited to circular shapes and may be, for example, centroid-aligned polygonal shapes.

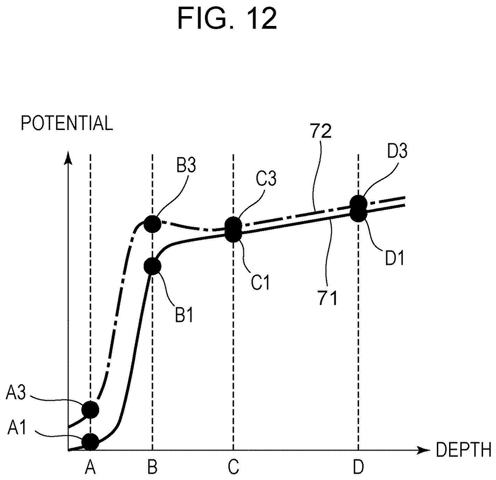

A method of inhibiting the sensitivity from decreasing in a manner in which a photogenerated charge that is detected in a region in which an APD in the inactive state is present is guided to an APD in the active state will be described with reference to a potential diagram in Fig. 12. A solid line 71 in Fig. 12 represents the potential distribution of line EE' in Fig. 9, and a dotted line 72 in Fig. 12 represents the potential distribution of line GG' in Fig. 9. In a case described below, an electric potential for putting the APD illustrated on line EE' into the active state is applied to the cathode, and an electric potential for putting the APD illustrated on line GG' into the inactive state is applied to the cathode. The solid line 71 in Fig. 12 is equivalent to the solid line 71 in Fig. 10.

In Fig. 12, the potential height of the solid line 71 at the depth A is A1, the potential height of the dotted line 72 at the depth A is A3, the potential height of the solid line 71 at the depth B is B1, and the potential height of the dotted line 72 at the depth B is B3. The potential height of the solid line 71 at the depth C is C1, the potential height of the dotted line 72 at the depth C is C3, the potential height of the solid line 71 at the depth D is D1, and the potential height of the dotted line 72 at the depth D is D3.

As for the solid line 71 in Fig. 12, the potential gradually decreases from the depth D to the depth C and from the depth C to the depth B and is at a B1 level at the depth B. The potential sharply decreases from the depth B to the depth A, and the potential is at an A1 level at the depth A. At the depth D, the potentials of the dotted line 72 and the solid line 71 are at substantially the same height and have a potential gradient that gently decreases toward the second surface of the semiconductor layer 301 in a region illustrated by using line EE' and line GG'. For this reason, an electric charge that is generated in the light detection device moves toward the second surface with the gentle potential gradient.

The impurity concentrations of the first semiconductor region 311 and the second semiconductor region 312 are appropriately adjusted, and consequently, the presence or absence of a potential barrier at the depth B can be controlled by the electric potential that is applied to the cathode. As for the dotted line 72 in Fig. 12, in the case where an electric potential lower than that of the cathode on line EE' is applied to the cathode of the APD on line GG', the potential gradually decreases from the depth D to the depth C on line GG'. The potential gradually increases from the depth C to the depth B, and the potential is at a B3 level at the depth B. The potential decreases from the depth B to the depth A and is at an A3 level at the depth A.

A photoelectrically converted electron in the fourth semiconductor region 314 on line GG' in Fig. 9 moves from the potential D3 to C3 in Fig. 12, but cannot cross C3 to B3 because this is a potential barrier for the electron. For this reason, the electron moves toward the fourth semiconductor region 314 on line EE' in Fig. 9. The moved electron moves from the potential gradient C1 to B1 in Fig. 12, causes the avalanche multiplication to occur due to the sharp potential gradient from B1 to A1, passes through the first semiconductor region 311, and is subsequently detected as a signal charge. That is, a photogenerated charge that is generated near an APD in the inactive state is guided to an APD in the active state by using the potential barrier, and the sensitivity can be inhibited from decreasing.

According to the second embodiment described above, a photogenerated charge that is detected in a region in which an APD in the inactive state is present is guided to an APD in the active state, and consequently, the sensitivity can be inhibited from decreasing.

### <Third Embodiment>

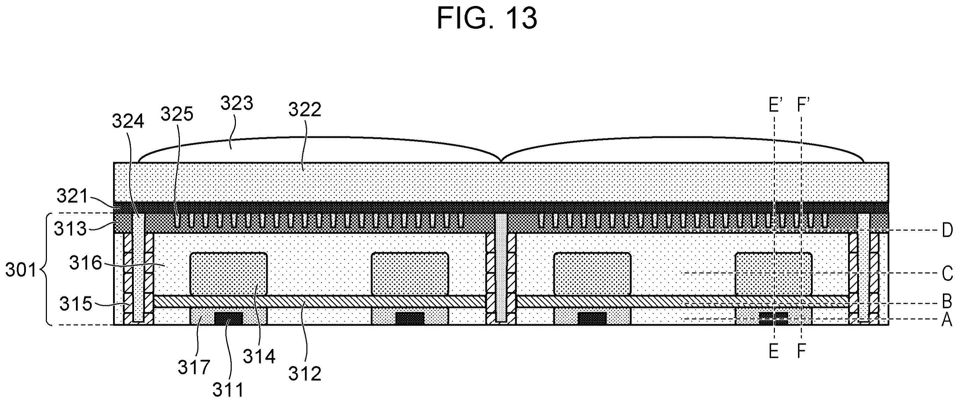

The structure of a photoelectric conversion apparatus according to a third embodiment will be described with reference to Fig. 13 to Fig. 15B. In the following description, components common to those according to the first and second embodiments are designated by using like reference signs, and the description thereof is omitted in some cases.

Fig. 13 is a sectional view of the photoelectric conversion elements 102 of two pixels of the photoelectric conversion apparatus according to the third embodiment, taken along a direction perpendicular to a surface direction of a substrate.

As for the photoelectric conversion apparatus according to the present embodiment, a trench-based uneven surface structure 325 is formed on the light incident surface of a semiconductor layer. The uneven surface structure 325 is surrounded by the third semiconductor region 313 of the P-type and scatters light incident on the photoelectric conversion elements 102. The incident light advances obliquely in the photoelectric conversion elements, an optical path length equal to or greater than the thickness of the semiconductor layer 301 can accordingly be ensured, and light having a longer wavelength than that in the case where the uneven surface structure 325 is not provided can be photoelectrically converted. The uneven surface structure 325 prevents the incident light from being reflected in the substrate, and accordingly, the efficiency of photoelectric conversion of the incident light can be improved.

The fourth semiconductor region 314 and the uneven surface structure 325 are formed so as to overlap in plan view. Overlapping areas of the fourth semiconductor region 314 and the uneven surface structure 325 in plan view are larger than the area of a portion of the fourth semiconductor region 314 that does not overlap the uneven surface structure 325. An electric charge that is generated at a position far from an avalanche multiplication region formed between the first semiconductor region 311 and the fourth semiconductor region 314 takes longer to reach the avalanche multiplication region than an electric charge that is generated at a position near the avalanche multiplication region. For this reason, timing jitter can become worse. An electric field at a photodiode deep portion can be increased in a manner in which the fourth semiconductor region 314 and the uneven surface structure 325 are disposed so as to overlap in plan view, the collection time of the electric charge that is generated at the position far from the avalanche multiplication region can be reduced, and accordingly, the timing jitter can be reduced.

In addition, thermally excited electric charges can be inhibited from being generated at an interface portion of the uneven surface structure 325 in a manner in which the third semiconductor region 313 three-dimensionally covers the uneven surface structure 325. Consequently, the DCR (Dark Count Rate) of the photoelectric conversion elements 102 can be reduced.

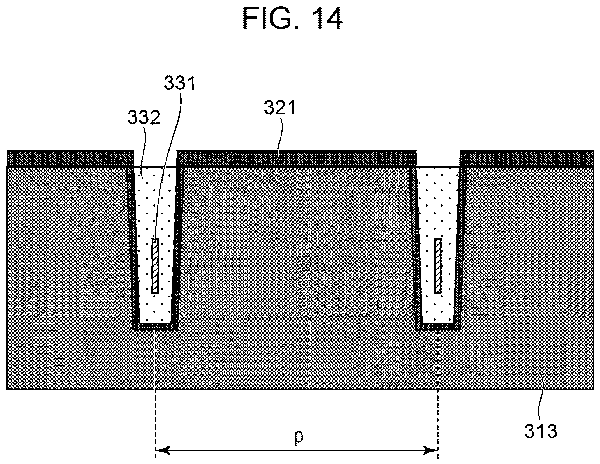

Fig. 14 is an enlarged sectional view of two trenches among trenches for forming the uneven surface structure 325 of the photoelectric conversion apparatus according to the third embodiment.

A trench structure is composed of a material containing a material different from that of the third semiconductor region 313. For example, in the case where the third semiconductor region 313 is composed of silicon, a main member of the trench structure is a silicon oxide film or a silicon nitride film but may contain metal or an organic material. For example, the trenches are formed at a depth of 0.1 to 0.6 µm from a surface of the semiconductor layer. A trench depth is preferably greater than a trench width in order to sufficiently increase the effect of diffraction of the incident light. The trench width described herein refers to a distance from an interface between the pinning film 321 and the third semiconductor region 313 to an interface between the pinning film 321 and the third semiconductor region 313 along a plane passing through the center of gravity of a trench cross-section. The trench depth refers to a distance from the light incident surface of the semiconductor layer 301 to a trench bottom portion.

A cycle p illustrated by using an arrow in Fig. 14 represents one cycle of the uneven surface structure 325 that is formed by the multiple trenches. The cycle of the uneven surface structure 325 is defined as a distance from the center of gravity of a trench of the uneven surface structure 325 to the center of gravity of another trench adjacent to the trench in the sectional view, and an effective cycle is defined as the average of cycles of the entire uneven surface of the uneven surface structure 325.

Trench formation processing will now be described. A groove is first formed on the third semiconductor region 313 of the semiconductor layer 301 by etching. Subsequently, the pinning film 321 is formed on a surface of the third semiconductor region 313 and on the insides of the trenches by using, for example, a chemical vapor deposition method. Filling members 332 are filled over the insides of the trenches that are covered by the pinning film 321. The trenches for forming the uneven surface structure 325 can be filled in the same process as trenches for forming the pixel separation portion 324. In this case, sidewall portions of the trenches for forming the uneven surface structure 325 and sidewall portions of the trenches for forming the pixel separation portion 324 have substantially the same impurity concentration.

The filling members 332 contain voids 331. The refractive index of the voids 331 is lower than the refractive index of the filling members 332, and accordingly, optical paths along which light passes through the voids and optical paths along which light passes through other portions differ from each other. The refractive index difference of the uneven surface structure 325 as a whole is larger than that in the case where the filling members contain no voids, the phase difference of light that passes through the uneven surface structure 325 increases, and accordingly, the diffraction of the incident light is likely to increase. That is, the voids that are contained in the filling members increase the intensity of the incident light at a specific phase, and the sensitivity can be improved. The filling members 332 may not contain the voids 331.

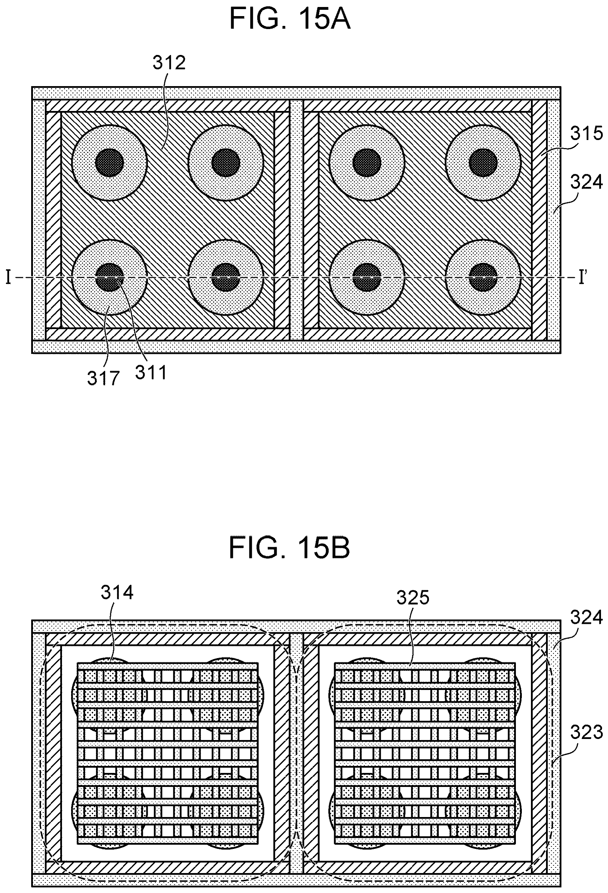

Fig. 15A and Fig. 15B are plan views of the photoelectric conversion elements 102 of two pixels of the photoelectric conversion apparatus according to the third embodiment. Fig. 15A is the plan view when viewed from a surface opposite the light incident surface. Fig. 15B is the plan view when viewed from the light incident surface. Fig. 13 can be said as a sectional view taken along line II' in Fig. 15A.

In Fig. 15B, the uneven surface structure 325 has a lattice shape in plan view. The uneven surface structure 325 is formed so as to overlap the first semiconductor region 311 and the fourth semiconductor region 314. Bottom portions of trenches at which the trenches intersect with each other are nearer than the half of the thickness of the semiconductor layer 301 to the light incident surface. The trench depth can also refer to a distance from the second surface described above to each bottom portion and can also refer to the depth of a recessed portion of the uneven surface structure 325.

According to the third embodiment described above, the uneven surface structure 325 scatters the light incident on the photoelectric conversion elements 102. The incident light advances obliquely in the photoelectric conversion elements, an optical path length equal to or greater than the thickness of the semiconductor layer 301 can accordingly be ensured, and light having a longer wavelength than that in the case where the uneven surface structure 325 is not provided can be photoelectrically converted.

### <Fourth Embodiment>

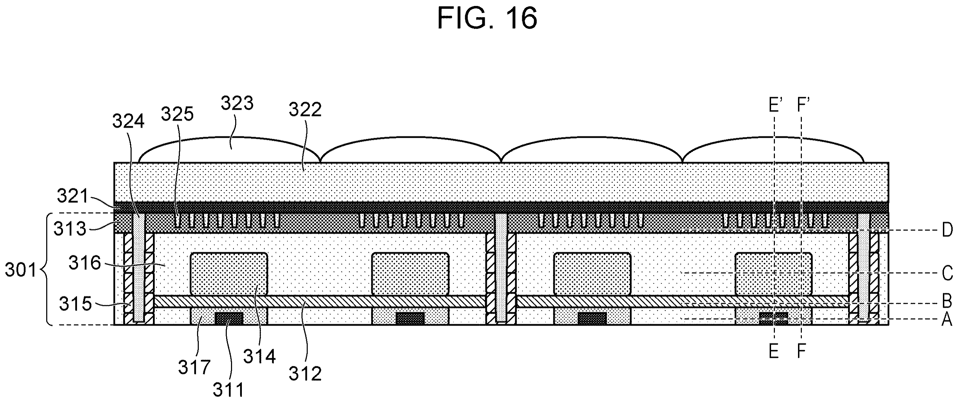

The structure of a photoelectric conversion apparatus according to a fourth embodiment will be described with reference to Fig. 16 to Fig. 17B. In the following description, components common to the first to third embodiments are designated by using like reference signs, and the description thereof is omitted in some cases.

Fig. 16 is a sectional view of the photoelectric conversion elements 102 of two pixels of the photoelectric conversion apparatus according to the fourth embodiment, taken along a direction perpendicular to a surface direction of a substrate. A difference from the third embodiment is that multiple APDs of pixels include the respective microlenses 323 and the respective uneven surface structures 325.

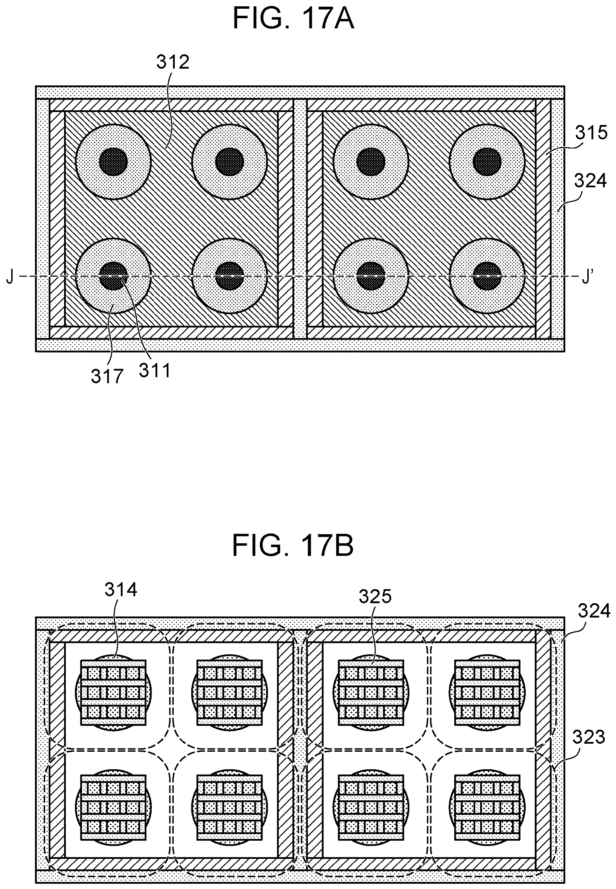

Fig. 17A and Fig. 17B are plan views of the photoelectric conversion elements 102 of two pixels of the photoelectric conversion apparatus according to the fourth embodiment.

Fig. 17A is the plan view when viewed from a surface opposite the light incident surface. Fig. 17B is the plan view when viewed from the light incident surface. Fig. 16 can be said as a sectional view taken along line JJ' in Fig. 17A.

In Fig. 17B, the photoelectric conversion element 102 of each pixel includes four APDs, and each APD includes the microlens 323 and the uneven surface structure 325. The position of the center of gravity of the uneven surface structure 325 is inside the avalanche multiplication region in plan view.

Four microlenses 323 formed in each pixel enable light to be focused with a higher curvature than that in the case where a single microlens 323 is formed in each pixel even when lens thicknesses are the same. This enables light to be collected in a region near the avalanche multiplication region, and accordingly, the response speed of photon detection can be improved.

### <Fifth Embodiment>

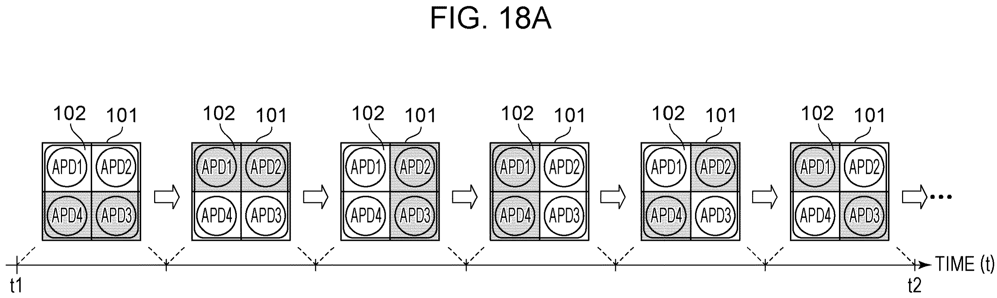

A method of driving a photoelectric conversion apparatus according to a fifth embodiment will be described with reference to Fig. 18A to Fig. 18C. In the following description, components common to the first to fourth embodiments are designated by using like reference signs, and the description thereof is omitted in some cases.

As illustrated in Fig. 8A and Fig. 8B, when each photoelectric conversion element 102 includes two or more APDs, and each APD is alternately or periodically put into the active state, a side effect can be a decrease in the sensitivity. However, if the number of APDs that are put into the active state in order to inhibit the sensitivity from decreasing is increased, the power consumption increases, and the degradation of the device characteristics is accelerated. That is, the sensitivity, the power consumption, and the device characteristics are in a trade-off relationship.

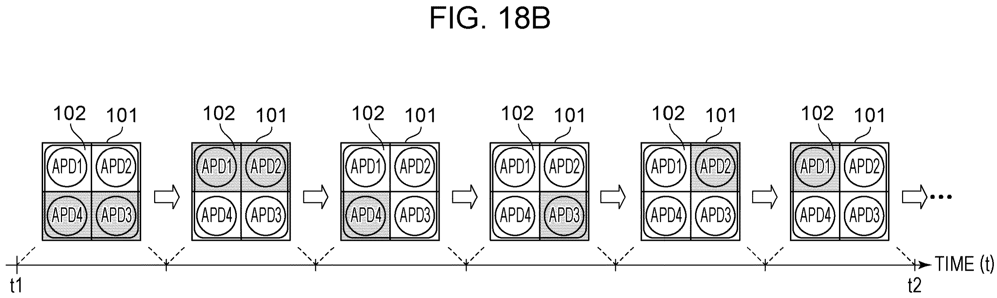

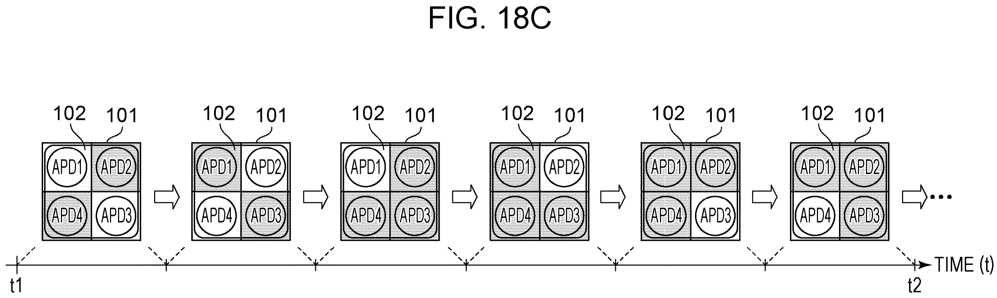

In the method of driving the photoelectric conversion apparatus according to the fifth embodiment, the number and arrangement of APDs in the active state and APDs in the inactive state in one pixel are changed over time. Fig. 18A, Fig. 18B, and Fig. 18C are schematic diagrams illustrating three examples in which each photoelectric conversion element 102 includes four APDs, and six patterns are repeated for drive. White regions represent active regions of a pixel 101, and gray regions represent inactive regions of the pixel 101.

In Fig. 18A, a period from time t1 to time t2 is one cycle, and active regions and inactive regions repeat six patterns per cycle. As for the pattern illustrated in Fig. 18A, the ratio of time during which each APD is in the active state is expressed as 12/24 (= 1/2) unlike the case of Fig. 8B in which each APD is always in the active state.

In this case, the sensitivity, the power consumption due to the avalanche multiplication, and the rate of degradation of the device characteristics are about twice that in the case of Fig. 8A in which the ratio of time during which each APD is in the active state is 1/4 of that in the case where each APD is always in the active state. The sensitivity, the power consumption due to the avalanche multiplication, and the rate of degradation of the device characteristics are about 1/2 of that in the case of Fig. 8B in which the four APDs are always in the active state.

Since it is known that the sensitivity is about 1/2 times that in the case of Fig. 8B, the decrease in the sensitivity may be corrected in a subsequent process, not illustrated, in which the count value of the counter circuit 211 is multiplied by 2/1 of the multiplicative inverse of the sensitivity. In other words, the count value may be corrected depending on the ratio of the period during which each APD is in the standby state and in the active state to the exposure period.

In Fig. 18B, a period from time t1 to time t2 is one cycle, and active regions and inactive regions repeat six patterns per cycle. In Fig. 18B, the ratio of time during which each APD is in the active state is expressed as 16/24 (= 2/3) unlike the case of Fig. 8B in which each APD is always in the active state.

In this case, the sensitivity, the power consumption, and the rate of degradation of the device characteristics are about 2/3 / 1/4 = 8/3 times that in the case of Fig. 8A in which the ratio of time during which each APD is in the active state is 1/4 of that in the case where each APD is always in the active state. The sensitivity, the power consumption, and the rate of degradation of the device characteristics are about 2/3 / 1 = 2/3 times that in the case of Fig. 8B in which the four APDs are always in the active state.

Since it is known that the sensitivity is about 2/3 times that in the case of Fig. 8B, the decrease in the sensitivity may be corrected in a subsequent process, not illustrated, in which the count value of the counter circuit 211 is multiplied by 3/2 of the multiplicative inverse.

In Fig. 18C, a period from time t1 to time t2 is one cycle, and active regions and inactive regions repeat six patterns per cycle. In Fig. 18C, the ratio of time during which each APD is in the active state is expressed as 8/24 (= 1/3) unlike the case of Fig. 8B in which each APD is always in the active state.

In this case, the sensitivity, the power consumption, and the rate of degradation of the device characteristics are about 1/3 / 1/4 = 4/3 times that in the case of Fig. 8A in which the ratio of time during which each APD is in the active state is 1/4. The sensitivity, the power consumption, and the rate of degradation of the device characteristics are about 1/3 / 1 = 1/3 times that in the case of Fig. 8B in which the four APDs are always in the active state.

Since it is known that the sensitivity is about 1/3 times that in the case of Fig. 8B, the decrease in the sensitivity may be corrected in a subsequent process, not illustrated, in which the count value of the counter circuit 211 is multiplied by 3/1 of the multiplicative inverse.

According to the fifth embodiment described above, the number and arrangement of APDs in the active state and APDs in the inactive state in one pixel are changed over time, and consequently, the degree of freedom of setting the device characteristics, the power consumption, and the sensitivity can be improved. This enables the photoelectric conversion apparatus to be appropriately driven depending on whether the sensitivity is prioritized or the power consumption and the device characteristics are prioritized. The sensitivity can be inhibited from decreasing in a subsequent process, not illustrated, in which the count value of the counter circuit 211 is corrected.

As described according to the second embodiment with reference to Fig. 8A and Fig. 8B, when each photoelectric conversion element 102 includes two or more APDs, and each APD is alternately or periodically put into the active state, the side effect can be the decrease in the sensitivity. In a method of driving a photoelectric conversion apparatus according to a sixth embodiment, each APD is alternately or periodically put into the active state, and consequently, the device characteristics are inhibited from being degraded, in a use case in which the influence of the decrease in the sensitivity is small.

An example of an electronic device for which the photoelectric conversion apparatus 100 is used is a digital camera. It is known that the digital camera has a function of automatically adjusting exposure, that is, AE (Automatic Exposure) such that a photographed image is appropriately bright regardless of the brightness of an object. To fulfill this function, a subsequent process, not illustrated, includes acquiring information about the brightness of the object such as an integrated value of pixel values from the photoelectric conversion apparatus 100.

According to the present embodiment, the photoelectric conversion apparatus 100 is driven by using an idea similar to this. In the case where the information about the brightness of the object is acquired in the subsequent process, not illustrated, and it is determined that the current frame has high illuminance, there is a high possibility of saturation even when a photograph is taken at low sensitivity. For this reason, each APD is alternately or periodically put into the active state in a next frame, and consequently, the device characteristics are inhibited from being degraded. In the case where it is not determined that the current frame has high illuminance, all of the APDs are controlled into the active state, and incident photons are detected without omission.

Alternatively, feedforward control may be used to determine whether each APD is alternately or periodically put into the active state depending on the photographic conditions of the digital camera such as a standby mode, an F-value, and ISO sensitivity.

In the standby mode, the photoelectric conversion apparatus 100 does not take a photograph, there is no influence of the decrease in the sensitivity, and the device characteristics are inhibited from being degraded by alternately or periodically putting each APD into the active state.

In the case where the F-value is small, the likelihood of high illuminance is high, there is a high possibility that counter saturation occurs even when a photograph is taken at low sensitivity, and accordingly, the device characteristics are inhibited from being degraded by alternately or periodically putting each APD into the active state.

Similarly, in the case where the ISO sensitivity is low, a high illuminance condition exists, there is a high possibility that the counter saturation occurs even when a photograph is taken at low sensitivity, and accordingly, the device characteristics are inhibited from being degraded by alternately or periodically putting each APD into the active state.

In a use case in which the influence of the decrease in the sensitivity is small, each APD is alternately or periodically put into the active state, and consequently, the device characteristics can be inhibited from being degraded.

### <Sixth Embodiment>

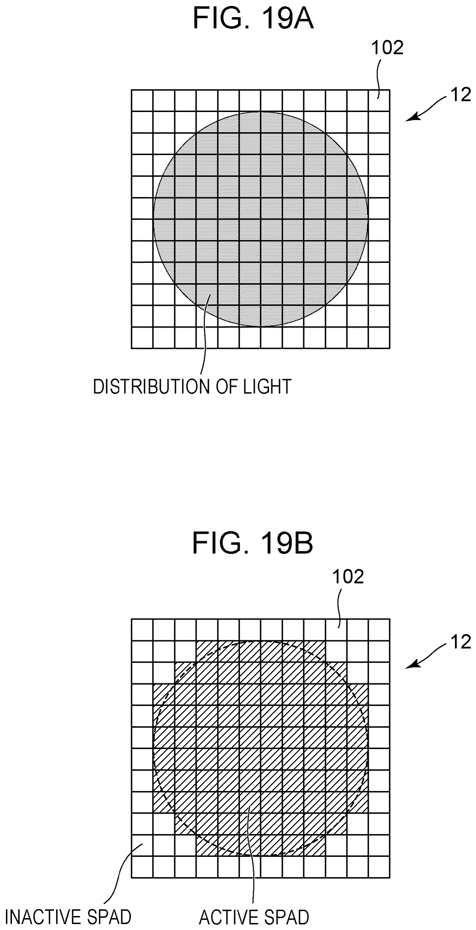

A sixth embodiment will be described with reference to Fig. 19A and Fig. 19B.

According to the embodiments described above, each pixel of the photoelectric conversion elements 102 includes multiple APDs. As for the photoelectric conversion elements 102 according to the present embodiment, each pixel includes a single APD. According to the present embodiment, an avalanche diode of a pixel within a first region in the imaging region of the photoelectric conversion apparatus 100 is put into the active state, an avalanche photodiode of a pixel within a second region is put into the inactive state, and consequently, the power consumption is reduced. For example, the first region described herein may be a region (such as a central portion of the imaging region) that is irradiated with light. For example, the second region may be a region nearer than the first region to an outer peripheral portion of the imaging region that is not irradiated with light. The operation of each APD of the photoelectric conversion apparatus according to the present embodiment is the same as any one of those according to the first to fifth embodiments.

Fig. 19A and Fig. 19B are schematic diagrams illustrating the distribution of light incident on the pixel region 12 and the distribution of the active state/inactive state of each photoelectric conversion element 102 in the pixel region 12. Fig. 19A illustrates the distribution of light, and Fig. 19B illustrates whether each photoelectric conversion element 102 is held in the active state or the inactive state. In the pixel region 12, light is likely to be incident particularly on a central portion, but light is unlikely to be incident on an outer peripheral portion. According to the present embodiment, only photoelectric conversion elements 102 in a region on which light is incident are controlled so as to enter the active state, and consequently, the power consumption can be reduced.

### <Seventh Embodiment>

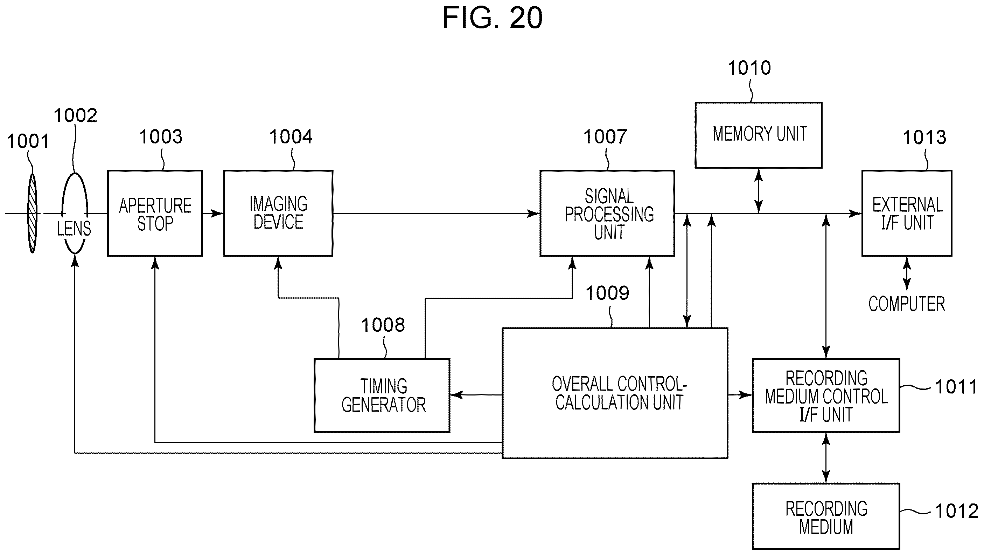

A photoelectric conversion system according to the present embodiment will be described with reference to Fig. 20. Fig. 20 is a block diagram schematically illustrating the structure of the photoelectric conversion system according to the present embodiment.

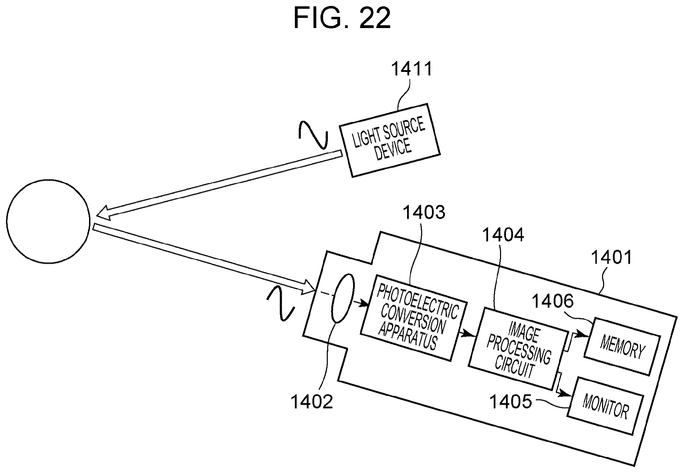

The photoelectric conversion apparatuses according to the embodiments described above can be used for various photoelectric conversion systems. Examples of the photoelectric conversion systems to be used include a digital still camera, a digital camcorder, a surveillance camera, a copier, a facsimile machine, a mobile phone, a vehicle-mounted camera, and an observation satellite. A camera module that includes an optical system such as a lens and an imaging device is included in the examples of the photoelectric conversion systems. Fig. 22 illustrates a block diagram in which the digital still camera is taken as an example.

The photoelectric conversion system illustrated in Fig. 20 by way of example includes an imaging device 1004 that is an example of a photoelectric conversion apparatus and a lens 1002 that images an optical image of an object on the imaging device 1004. The photoelectric conversion system includes an aperture stop 1003 for making the amount of light to pass through the lens 1002 variable and a barrier 1001 for protecting the lens 1002. The lens 1002 and the aperture stop 1003 are optical systems for focusing light on the imaging device 1004. The imaging device 1004 is the photoelectric conversion apparatus according to any one of the embodiments described above and converts the optical image that is imaged by the lens 1002 into an electric signal.

The photoelectric conversion system includes a signal processing unit 1007 that is an image generating unit that generates an image by processing an output signal outputted by the imaging device 1004. The signal processing unit 1007 outputs image data after various corrections and compression as needed. The signal processing unit 1007 may be formed in a semiconductor layer in which the imaging device 1004 is provided or may be formed in another semiconductor layer that differs from that for the imaging device 1004. The imaging device 1004 and the signal processing unit 1007 may be formed in the same semiconductor layer.

The photoelectric conversion system further includes a memory unit 1010 for temporarily storing the image data and an external interface unit (an external I/F unit) 1013 for communicating with, for example, an external computer. The photoelectric conversion system further includes a recording medium 1012 such as a semiconductor memory for recording or reading imaging data and a recording medium control interface unit (a recording medium control I/F unit) 1011 for recording in or reading from the recording medium 1012. The recording medium 1012 may be contained in the photoelectric conversion system and may be removable.

The photoelectric conversion system further includes an overall control-calculation unit 1009 that controls various calculations and the entire digital still camera and a timing generator 1008 that outputs various timing signals to the imaging device 1004 and the signal processing unit 1007. The timing signals, for example, may be inputted from the outside, provided that the photoelectric conversion system includes at least the imaging device 1004 and the signal processing unit 1007 that processes the output signal outputted from the imaging device 1004.

The imaging device 1004 outputs an imaging signal to the signal processing unit 1007. The signal processing unit 1007 performs a predetermined signal process on the imaging signal outputted from the imaging device 1004 and outputs an image data. The signal processing unit 1007 generates an image by using the imaging signal.

According to the present embodiment, the photoelectric conversion system that includes the photoelectric conversion apparatus (the imaging device) according to any one of the embodiments described above can be provided as described above.

### <Eighth Embodiment>

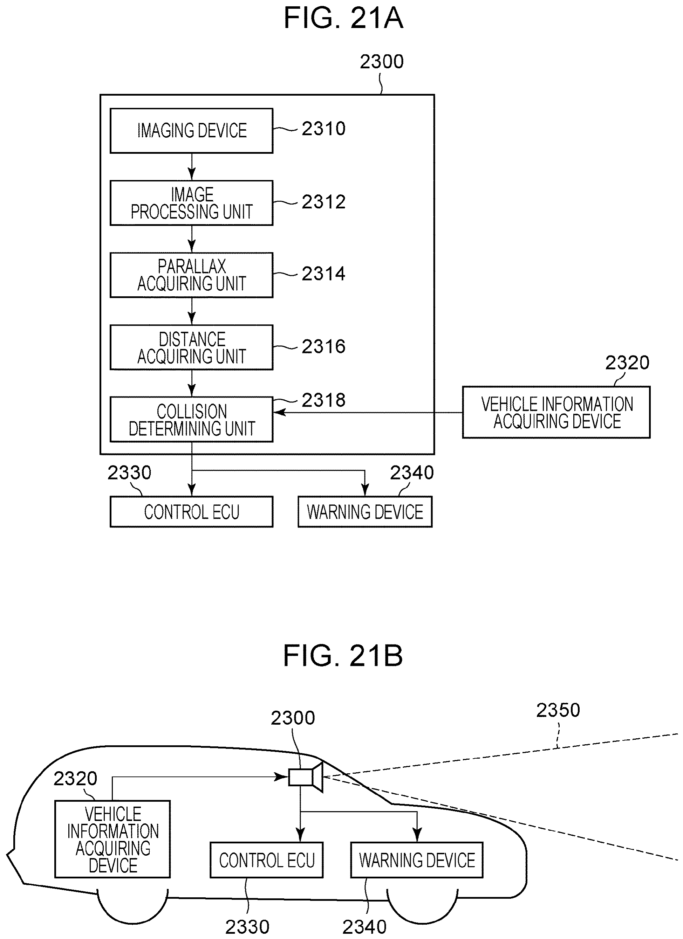

A mobile body and a photoelectric conversion system according to the present embodiment will be described with reference to Fig. 21A and Fig. 21B. Fig. 21A and Fig. 21B illustrate the structure of the mobile body and the photoelectric conversion system according to the present embodiment.

Fig. 21A illustrates an example of a photoelectric conversion system regarding a vehicle-mounted camera. A photoelectric conversion system 2300 includes an imaging device 2310. The imaging device 2310 is the photoelectric conversion apparatus according to any one of the embodiments described above. The photoelectric conversion system 2300 includes an image processing unit 2312 that performs image processing on multiple pieces of image data acquired by the imaging device 2310. The photoelectric conversion system 2300 includes a parallax acquiring unit 2314 that calculates a parallax (a phase difference in a parallax image) from the multiple pieces of image data acquired by the photoelectric conversion system 2300. The photoelectric conversion system 2300 further includes a distance acquiring unit 2316 that calculates a distance to an object, based on the calculated parallax and a collision determining unit 2318 that determines whether a collision can occur based on the calculated distance. The parallax acquiring unit 2314 and the distance acquiring unit 2316 are examples of a distance information acquiring means that acquires distance information to the object. That is, the distance information may be acquired by using not only the phase difference but also a ToF (Time Of FLigHt) technique. The collision determining unit 2318 may determine whether a collision can occur by using the distance information. The distance information acquiring means may be provided by using dedicated hardware or may be provided by using a software module. For example, an FPGA (FieLd ProgrammabLe Gate Array), or an ASIC (AppLication Specific Integrated Circuit) may be used, or a combination thereof may be used.

The photoelectric conversion system 2300 is connected to a vehicle information acquiring device 2320 and can acquire vehicle information such as a vehicle speed, a yaw rate, and a steering angle. A control ECU 2330 that is a control device (a controller) that outputs a control signal for generating braking force for a vehicle, based on the result of determination of the collision determining unit 2318 is connected to the photoelectric conversion system 2300. The photoelectric conversion system 2300 is connected also to a warning device 2340 that warns a driver, based on the result of determination of the collision determining unit 2318. For example, in the case where the result of determination of the collision determining unit 2318 indicates a high possibility of collision, the control ECU 2330 implements vehicle control for avoiding a collision or reducing damage, for example, by braking, releasing an accelerator, or reducing an engine output. The warning device 2340 warns a user, for example, by giving a warning such as a sound, displaying warning information on a screen such as a car navigation system, or applying a vibration to a seat belt or a steering wheel.

According to the present embodiment, the photoelectric conversion system 2300 images the vicinity of the vehicle such as a location in front of or behind the vehicle. Fig. 21B illustrates a photoelectric conversion system in the case where a location in front of the vehicle (an imaging range 2350) is imaged. The vehicle information acquiring device 2320 transmits an instruction to the photoelectric conversion system 2300 or the imaging device 2310. With this structure, the accuracy of distance measurement can be improved.

In an example described above, control for avoiding a collision with another vehicle is implemented. However, control for autonomous driving during tracking another vehicle or control for autonomous driving within a lane can be implemented. The photoelectric conversion system is not limited to a vehicle such as an automobile but can be used also for a mobile body (a mobile device) such as a vessel, an aircraft, or an industrial robot. In addition, the photoelectric conversion system is not limited to a mobile body but can be widely used for devices that use object recognition such as intelligent transport systems (ITS).

### <Ninth Embodiment>

A photoelectric conversion system according to the present embodiment will be described with reference to Fig. 22. Fig. 22 is a block diagram illustrating an example of the structure of a distance image sensor that corresponds to the photoelectric conversion system.

As illustrated in Fig. 22, a distance image sensor 1401 includes an optical system 1402, a photoelectric conversion apparatus 1403, an image processing circuit 1404, a monitor 1405, and a memory 1406. The distance image sensor 1401 receives light (modulated light or pulse light) that is emitted from a light source device 1411 toward an object and that is reflected by a surface of the object and can consequently acquire a distance image depending on a distance to the object.

The optical system 1402 includes one or multiple lenses, guides image light (incident light) from the object to the photoelectric conversion apparatus 1403 and images the image light on a light reception surface (a sensor portion) of the photoelectric conversion apparatus 1403.

The photoelectric conversion apparatus 1403 uses the photoelectric conversion apparatus according to any one of the embodiments described above, and a distance signal representing a distance acquired from a received-light signal outputted from the photoelectric conversion apparatus 1403 is supplied to the image processing circuit 1404.

The image processing circuit 1404 performs image processing for forming the distance image based on the distance signal that is supplied from the photoelectric conversion apparatus 1403. The distance image (image data) acquired by the image processing is supplied to the monitor 1405 and is displayed or is supplied to the memory 1406 and is stored (recorded).

For example, the distance image sensor 1401 thus configured can acquire an accurate distance image because pixel characteristics are improved by using the photoelectric conversion apparatus described above.

### <Tenth Embodiment>

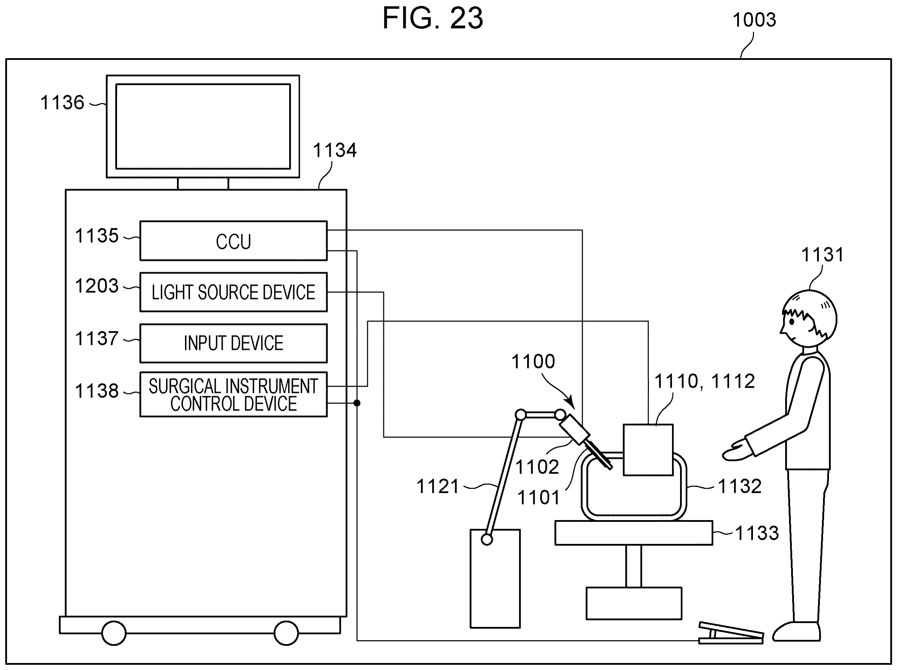

A photoelectric conversion system according to the present embodiment will be described with reference to Fig. 23. Fig. 23 schematically illustrates an example of the structure of an endoscopic surgery system that corresponds to the photoelectric conversion system according to the present embodiment.

In Fig. 23, an operator (a doctor) 1131 performs surgery to a patient 1132 on a patient bed 1133 by using an endoscopic surgery system 1103. As illustrated, the endoscopic surgery system 1103 includes an endoscope 1100, a surgical instrument 1110, and a cart 1134 on which various devices for endoscopic surgery are mounted.

The endoscope 1100 includes a lens tube 1101 that has a region having a predetermined length from the distal end thereof to be inserted into a body cavity of the patient 1132 and a camera head 1102 that is connected to the proximal end of the lens tube 1101. In an illustrated example, the endoscope 1100 is configured as a so-called rigid scope including the lens tube 1101 that is rigid, but the endoscope 1100 may be configured as a so-called soft scope including a soft lens tube.

An opening portion in which an objective lens is embedded is provided at an end of the lens tube 1101. A light source device 1203 is connected to the endoscope 1100, and light that is generated by the light source device 1203 is guided to the end of the lens tube by using a light guide extending in the lens tube 1101 and is radiated toward an object to be observed in the body cavity of the patient 1132 via the objective lens. The endoscope 1100 may be a forward-viewing scope, an oblique-viewing scope, or a side-viewing scope.

An optical system and a photoelectric conversion apparatus are provided in the camera head 1102, and the optical system focuses reflection light (observation light) from the object to be observed on the photoelectric conversion apparatus. The photoelectric conversion apparatus photoelectrically converts the observation light and generates an electric signal corresponding to the observation light, that is, an image signal corresponding to an observation image. The photoelectric conversion apparatus can be the photoelectric conversion apparatus according to any one of the embodiments described above. The image signal is transmitted as RAW data to a camera control unit (CCU) 1135.

For example, the CCU 1135 includes a CPU (CentraL Processing Unit) or a GPU (GrapHics Processing Unit) and collectively controls the operation of the endoscope 1100 and a display device 1136. The CCU 1135 receives the image signal from the camera head 1102 and performs various kinds of image processing for displaying an image based on the image signal such as a developing process (a de-mosaic process) on the image signal.

The display device 1136 displays an image based on the image signal on which the image processing is performed by the CCU 1135 under the control of the CCU 1135.

For example, the light source device 1203 includes a light source such as an LED (LigHt Emitting Diode) and supplies irradiation light for photographing an affected area to the endoscope 1100.

An input device 1137 is an input interface for the endoscopic surgery system 1103. The user can input various kinds of information or instructions into the endoscopic surgery system 1103 by using the input device 1137.

A surgical instrument control device 1138 controls the drive of an energy surgical instrument 1112 for, for example, tissue cauterization, incision, or vessel sealing.

For example, the light source device 1203 that supplies the irradiation light for photographing the affected area to the endoscope 1100 includes a white light source that includes an LED, a laser light source, or a combination thereof. In the case where the white light source includes a combination of RGB laser light sources, an output timing and output intensity for colors (wavelengths) can be controlled with high precision, and consequently, the light source device 1203 can adjust the white balance of an imaged image. In this case, the object to be observed is time-divisionally irradiated with laser light from the RGB laser light sources, the drive of an imaging element of the camera head 1102 is controlled in synchronization with irradiation timing, and consequently, images corresponding to RGB can be time-divisionally imaged. This method enables a color image to be acquired even when the imaging element does not include a color filter.

The drive of the light source device 1203 may be controlled such that the intensity of light to be outputted is changed at predetermined intervals. The drive of the imaging element of the camera head 1102 is controlled in synchronization with the timing with which the intensity of light is changed, images are time-divisionally acquired, the images are composited, and consequently, a high dynamic range image without so-called crushed shadows and overexposure can be generated.

The light source device 1203 may be capable of supplying light in a predetermined wavelength band suitable for special light observation. For example, during the special light observation, the wavelength dependence of light absorption in body tissue is used. Specifically, light in a narrower band than that of the irradiation light (that is, white light) during normal observation is radiated, and consequently, predetermined tissue such as a blood vessel on a mucosal surface layer is photographed with high contrast. Alternatively, the special light observation may include fluorescence observation in which an image is acquired by using fluorescence that is generated by radiating excitation light. During the fluorescence observation, fluorescence from the body tissue can be observed by irradiating body tissue with excitation light, or a fluorescent image can be acquired by locally injecting a reagent such as indocyanine green (ICG) into the body tissue and irradiating the body tissue with excitation light suitable for the fluorescent wavelength of the reagent. The light source device 1203 may be capable of supplying narrowband light and/or excitation light suitable for the special light observation.

### <Eleventh Embodiment>

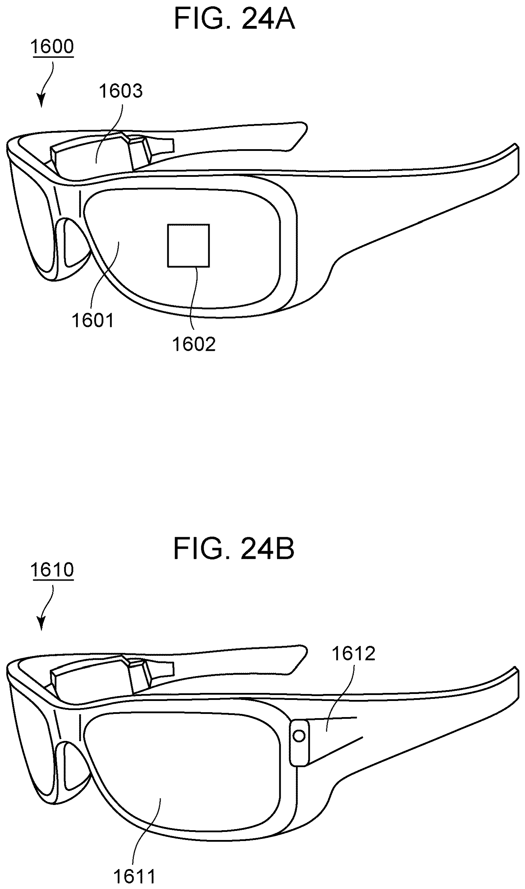

A photoelectric conversion system according to the present embodiment will be described with reference to Fig. 24A and Fig. 24B. Fig. 24A illustrates an example of the structure of glasses 1600 (smart glasses) that correspond to the photoelectric conversion system. The glasses 1600 include a photoelectric conversion apparatus 1602. The photoelectric conversion apparatus 1602 is the photoelectric conversion apparatus according to the twelfth embodiment described above. A display device including a light-emitting device such as an OLED or an LED may be provided on the back surface of a lens 1601. The photoelectric conversion apparatus 1602 may be one apparatus or multiple apparatuses. A combination of multiple kinds of photoelectric conversion apparatuses may be used. The position of the photoelectric conversion apparatus 1602 is not limited to that in Fig. 24A.

The glasses 1600 further include a control device 1603. The control device 1603 functions as a power supply that supplies power to the photoelectric conversion apparatus 1602 and the display device described above. The control device 1603 controls the operation of the photoelectric conversion apparatus 1602 and the display device. An optical system for focusing light on the photoelectric conversion apparatus 1602 is formed in the lens 1601.

Fig. 24B illustrates glasses 1610 (smart glasses) in an example. The glasses 1610 include a control device 1612, and the control device 1612 includes a photoelectric conversion apparatus corresponding to the photoelectric conversion apparatus 1602 and a display device. The photoelectric conversion apparatus in the control device 1612 and an optical system for projecting light emitted from the display device are formed in a lens 1611, and an image is projected on the lens 1611. The control device 1612 functions as a power supply that supplies power to the photoelectric conversion apparatus and the display device and controls the operation of the photoelectric conversion apparatus and the display device. The control device may include a gaze detection unit that detects wearer's gaze. Infrared may be used for gaze detection. An infrared light emitting unit emits infrared light toward the eyeball of the user who gazes a display image. Reflected light of the emitted infrared light from the eyeball is detected by an imaging unit including a light-receiving element, and consequently, an imaged image of the eyeball is acquired. Providing a reduction means that reduces light from the infrared light emitting unit to a display unit in plan view enables image quality to be inhibited from decreasing.

User's gaze with respect to the display image is detected from the imaged image of the eyeball that is acquired by imaging the infrared light. Any known method may be used for the gaze detection by using the imaged image of the eyeball. In an example, a gaze detection method based on a Purkinje image due to the reflection of the irradiation light at the cornea can be used.

More specifically, a gaze detection process based on a pupil-corneal reflection method is performed. A gaze vector representing the orientation (rotation angle) of the eyeball is calculated by using the pupil-corneal reflection method, based on a pupil image and the Purkinje image that are included in the imaged image of the eyeball, and consequently, the user's gaze is detected.

The display device according to the present embodiment may include a photoelectric conversion apparatus including a light-receiving element and may control a display image on the display device, based on information about the user's gaze from the photoelectric conversion apparatus.

Specifically, the display device determines a first visual field region at which the user gazes and a second visual field region other than the first visual field region, based on the information about the gaze. The first visual field region and the second visual field region may be determined by a control device in the display device, or those determined by an external control device may be received. In the display region of the display device, the display resolution of the first visual field region may be controlled so as to be higher than the display resolution of the second visual field region. That is, the resolution of the second visual field region may be lower than that of the first visual field region.

The display region may include a first display region and a second display region different from the first display region, and a high-priority region may be determined from the first display region and the second display region, based on the information about the gaze. The first visual field region and the second visual field region may be determined by the control device of the display device, or those determined by an external control device may be received. The resolution of the high-priority region may be controlled so as to be higher than the resolution of another region other than the high-priority region. That is, the resolution of a relatively low-priority region may be reduced.

The first visual field region and the high-priority region may be determined by using AI. The AI may be a model that estimates an angle of the gaze and a distance to an object that is the target of the gaze from the image of the eyeball by using, as training data, the image of the eyeball and the direction of the image that is actually viewed by the eyeball. The display device, the photoelectric conversion apparatus, or an external device may have an AI program. In the case where the external device has the AI program, transmission to the display device occurs through communication.

In the case of display control based on visual detection, this can be preferably used for smart glasses further including a photoelectric conversion apparatus that images the outside. The smart glasses can display imaged external information in real time.

The embodiments described above can be appropriately modified without departing from the technical concept. The embodiments of the present invention include an example acquired by adding a partial structure according to any one of the embodiments into another embodiment and an example acquired by being replaced with a partial structure according to another embodiment.

The disclosure according to the present embodiment includes structures and methods described below.

### (First structure)

A photoelectric conversion apparatus includes a first APD, and a first pulse generating circuit that generates a first pulse signal, based on an output from the first APD.

A first power supply that applies a first voltage to a first terminal of the first APD via a first switch, and a second power supply that applies a second voltage different from a voltage of the first power supply to a second terminal of the first APD are included. A third power supply that applies a third voltage different from the voltage of the first power supply and a voltage of the second power supply to the first terminal via a second switch is included. A period during which the first switch is on differs from a period during which the second switch is on.

### (Second structure)

When the first switch is turned on, the first APD enters a recharge state, and when the first switch is turned off, the first APD enters a standby state. As for the photoelectric conversion apparatus described in First structure, when the second switch is turned on, the first APD enters an inactive state, and when the second switch is turned off, the first APD enters an active state.

### (Third structure)

A photoelectric conversion apparatus includes a first APD, and a first pulse generating circuit that generates a first pulse signal, based on an output from the first APD. A first switch that is provided between a first power supply that applies a first voltage and a first terminal of the first APD, and a second switch that is provided between a second power supply that applies a second voltage different from the first voltage and the first terminal of the first APD are included. When the first switch is turned on, the first APD enters a recharge state, and when the first switch is turned off, the first APD enters a standby state. When the second switch is turned on, the first APD enters an inactive state, and when the second switch is turned off, the first APD enters an active state. A period during which the first switch is on differs from a period during which the second switch is on.

### (Fourth structure)

The photoelectric conversion apparatus further includes a second APD, and a second pulse generating circuit that generates a second pulse signal, based on an output from the second APD. A third switch that is provided between the first power supply that applies the first voltage and a first terminal of the second APD, and a fourth switch that is provided between the second power supply that applies the second voltage different from the first voltage and the first terminal of the second APD are included. When the third switch is turned on, the second APD enters a recharge state, and when the third switch is turned off, the second APD enters a standby state. When the fourth switch is turned on, the second APD enters an inactive state, and when the fourth switch is turned off, the second APD enters an active state. As for the photoelectric conversion apparatus described in Third structure, a period during which the third switch is on differs from a period during which the fourth switch is on.

### (Fifth structure)

A second period during which the second APD is in the standby state and in the active state starts after a first period during which the first APD is in the standby state and in the active state. As for the photoelectric conversion apparatus described in Second structure or Fourth structure, control is periodically implemented for the second switch and the fourth switch such that the first period starts again after the second period.

### (Sixth structure)

The first APD and the second APD each include a first semiconductor region of a first conductivity type, a second semiconductor region of a second conductivity type, and a third semiconductor region of the first conductivity type to which a signal charge moves from the first semiconductor region. A reverse bias voltage for avalanche multiplication of the signal charge is applied to the second semiconductor region and the third semiconductor region. As for the photoelectric conversion apparatus described in Fifth structure, a control unit moves the signal charge to the third semiconductor region of the second APD or the first APD in the active state.

### (Seventh structure)

As for the photoelectric conversion apparatus described in Sixth structure, the control unit is the second switch.

### (Eighth structure)

As for the photoelectric conversion apparatus described in any one of Fifth structure to Seventh structure, whether the control is implemented is set depending on a photographic condition.

### (Ninth structure)

The photoelectric conversion apparatus described in Second structure or any one of Fourth structure to Eighth structure further includes a counter that counts a pulse signal that is generated by the first pulse generating circuit, and a count value of the counter is corrected depending on a ratio of a period during which the first APD is in the standby state and in the active state to an exposure period for acquiring a single image.

### (Tenth structure)

The photoelectric conversion apparatus described in Second structure or any one of Fourth structure to Ninth structure further includes a third APD.

### (Eleventh structure)

The photoelectric conversion apparatus described in Second structure or any one of Fourth structure to Tenth structure further includes a first pixel and a second pixel, and a separation portion is provided between the first pixel and the second pixel.

### (Twelfth structure)

As for the photoelectric conversion apparatus described in Eleventh structure, an insulating isolation portion is not provided between the first APD and the second APD.

### (Thirteenth structure)

As for the photoelectric conversion apparatus described in any one of First structure to Twelfth structure, the second switch switches from a voltage that is applied to the first APD to a voltage higher than a breakdown voltage of the first APD or a voltage equal to or lower than the breakdown voltage.

### (Fourteenth structure)

Multiple pixels are arranged in a two-dimensional array in an imaging region. Control is implemented such that the first APD that is included in a pixel within a first region in the imaging region enters the active state, and the second APD that is included in a pixel within a second region in the imaging region enters the inactive state. Specifically, as for the photoelectric conversion apparatus described in Second structure or any one of Fourth structure to Thirteenth structure, the second switch and the fourth switch are controlled.

### (Fifteenth structure)

A photoelectric conversion system includes the photoelectric conversion apparatus described in any one of First structure to Fourteenth structure, and a signal processing unit that generates an image by using a signal outputted by the photoelectric conversion apparatus.

### (Sixteenth structure)

A mobile body includes the photoelectric conversion apparatus described in any one of First structure to Fourteenth structure, and a controller that controls movement of the mobile body by using a signal outputted by the photoelectric conversion apparatus.

The present invention is not limited to the embodiments described above, and various modifications and alterations can be made without departing from the spirit and scope of the present invention. Accordingly, the following claims are attached to make the scope of the present invention public.

This application claims the benefit of Japanese Patent Application No. 2023-106781 filed June 29, 2023, which is hereby incorporated by reference herein in its entirety. Reference Signs List

- 2011: APD
- 2012: APD
- 2101: waveform shaping unit
- 2102: waveform shaping unit
- 2021: PMOS transistor
- 2022: PMOS transistor
- 2031: NMOS transistor
- 2032: NMOS transistor

## Claims

1. A photoelectric conversion apparatus comprising:
a first avalanche photodiode;
a first pulse generating circuit that generates a first pulse signal, based on an output from the first avalanche photodiode;
a first power supply that applies a first voltage to a first terminal of the first avalanche photodiode via a first switch;
a second power supply that applies a second voltage different from a voltage of the first power supply to a second terminal of the first avalanche photodiode; and
a third power supply that applies a third voltage different from the voltage of the first power supply and a voltage of the second power supply to the first terminal via a second switch,
wherein a period during which the first switch is on differs from a period during which the second switch is on.

2. The photoelectric conversion apparatus according to claim 1, wherein when the first switch is turned on, the first avalanche photodiode enters a recharge state,
wherein when the first switch is turned off, the first avalanche photodiode enters a standby state,
wherein when the second switch is turned on, the first avalanche photodiode enters an inactive state, and
wherein when the second switch is turned off, the first avalanche photodiode enters an active state.

3. A photoelectric conversion apparatus comprising:
a first avalanche photodiode;
a first pulse generating circuit that generates a first pulse signal, based on an output from the first avalanche photodiode;
a first switch that is provided between a first power supply that applies a first voltage and a first terminal of the first avalanche photodiode; and
a second switch that is provided between a second power supply that applies a second voltage different from the first voltage and the first terminal of the first avalanche photodiode,
wherein when the first switch is turned on, the first avalanche photodiode enters a recharge state,
wherein when the first switch is turned off, the first avalanche photodiode enters a standby state,
wherein when the second switch is turned on, the first avalanche photodiode enters an inactive state,
wherein when the second switch is turned off, the first avalanche photodiode enters an active state, and
wherein a period during which the first switch is on differs from a period during which the second switch is on.

4. The photoelectric conversion apparatus according to claim 3, further comprising:
a second avalanche photodiode;
a second pulse generating circuit that generates a second pulse signal, based on an output from the second avalanche photodiode;
a third switch that is provided between the first power supply that applies the first voltage and a first terminal of the second avalanche photodiode;
a fourth switch that is provided between the second power supply that applies the second voltage different from the first voltage and the first terminal of the second avalanche photodiode,
wherein when the third switch is turned on, the second avalanche photodiode enters a recharge state,
wherein when the third switch is turned off, the second avalanche photodiode enters a standby state,
wherein when the fourth switch is turned on, the second avalanche photodiode enters an inactive state,
wherein when the fourth switch is turned off, the second avalanche photodiode enters an active state, and
wherein a period during which the third switch is on differs from a period during which the fourth switch is on.

5. The photoelectric conversion apparatus according to claim 4, wherein a second period during which the second avalanche photodiode is in the standby state and in the active state starts after a first period during which the first avalanche photodiode is in the standby state and in the active state, and
wherein control is periodically implemented for the second switch and the fourth switch such that the first period starts again after the second period.

6. The photoelectric conversion apparatus according to claim 5, wherein the first avalanche photodiode and the second avalanche photodiode each include a first semiconductor region of a first conductivity type, a second semiconductor region of a second conductivity type, and a third semiconductor region of the first conductivity type to which a signal charge moves from the first semiconductor region,
wherein a reverse bias voltage for avalanche multiplication of the signal charge is applied to the second semiconductor region and the third semiconductor region, and
wherein a control unit moves the signal charge to the third semiconductor region of the second avalanche photodiode or the first avalanche photodiode in the active state.

7. The photoelectric conversion apparatus according to claim 6, wherein the control unit is the second switch.

8. The photoelectric conversion apparatus according to claim 5, wherein whether the control is implemented is set depending on a photographic condition.

9. The photoelectric conversion apparatus according to claim 2 or claim 4, further comprising: a counter that counts a pulse signal that is generated by the first pulse generating circuit,
wherein a count value of the counter is corrected depending on a ratio of a period during which the first avalanche photodiode is in the standby state and in the active state to an exposure period for acquiring a single image.

10. The photoelectric conversion apparatus according to claim 2 or claim 4, further comprising: a third avalanche photodiode.

11. The photoelectric conversion apparatus according to claim 4, further comprising: a first pixel; and a second pixel,
wherein a separation portion is provided between the first pixel and the second pixel.

12. The photoelectric conversion apparatus according to claim 11, wherein an insulating isolation portion is not provided between the first avalanche photodiode and the second avalanche photodiode.

13. The photoelectric conversion apparatus according to claim 1, wherein the second switch switches from a voltage that is applied to the first avalanche photodiode to a voltage higher than a breakdown voltage of the first avalanche photodiode or a voltage equal to or lower than the breakdown voltage.

14. The photoelectric conversion apparatus according to claim 4, wherein multiple pixels are arranged in a two-dimensional array in an imaging region,
wherein the second switch and the fourth switch are controlled such that the first avalanche photodiode that is included in a pixel within a first region in the imaging region enters the active state, and the second avalanche photodiode that is included in a pixel within a second region in the imaging region enters the inactive state.

15. The photoelectric conversion apparatus according to claim 14, wherein in the imaging region, the second region is nearer than the first region to an outer peripheral portion.

16. A photoelectric conversion system comprising:
the photoelectric conversion apparatus according to any one of claim 1 to claim 15; and
a signal processing unit that generates an image by using a signal outputted by the photoelectric conversion apparatus.

17. A mobile body comprising:
the photoelectric conversion apparatus according to any one of claim 1 to claim 15; and
a controller that controls movement of the mobile body by using a signal outputted by the photoelectric conversion apparatus.
